# FASCICULE DE BREVET EUROPEEN

(11) **EP 3 520 182 B1**
(45) Date de publication et mention de la délivrance du brevet: **20.10.2021**
(21) Numéro de dépôt: 17784874.4
(22) Date de dépôt: 27.09.2017
(51) Int. Cl.: H01S 3/107, G01N 21/39, H01S 3/13, H01S 3/137, H01S 5/00, H01S 5/065, H01S 5/14

(54) **SYSTEME LASER AVEC RETROACTION OPTIQUE**
LASERSYSTEM MIT OPTISCHER RÜCKKOPPLUNG
LASER SYSTEM WITH OPTICAL FEEDBACK

(30) Priorité: 27.09.2016 FR 1659107
(43) Date de publication de la demande: 07.08.2019
(73) Titulaire: Centre National de la Recherche Scientifique, 75016 Paris (FR)
(72) Inventeur: KASSI, Samir, 38402 Saint Martin d'Hères (FR)
(74) Mandataire: Marks & Clerk France
(86) Numéro de dépôt international: PCT/EP2017/074549
(87) Numéro de publication internationale: WO 2018/060285

(56) Documents cités:
- WO-A1-03/031949
- US-A- 5 903 358
- US-A1- 2013 228 688
- US-B1- 6 466 322

## Description

### DOMAINE TECHNIQUE

La présente description concerne un système laser comprenant un laser couplé par rétroaction optique à une cavité optique résonante et un procédé de génération d'onde optique au moyen d'un tel système laser.

### ETAT DE L'ART

La demande de brevet WO 03/031949 décrit un système laser comprenant un laser couplé par rétroaction optique à une cavité optique résonante, externe au laser, pour la détection de traces de gaz. Une partie d'une onde source continue émise par le laser est injectée dans une cavité optique résonante par l'intermédiaire d'un système de couplage optique. La cavité optique se trouve dans une enceinte dans laquelle un gaz peut être injecté pour analyse. Une partie de l'onde optique générée dans la cavité optique résonante, appelée ici onde intra-cavité, est renvoyée vers le laser. Lorsque le laser est sensible à la rétroaction optique, ce qui est le cas par exemple des lasers à semi-conducteurs, un phénomène de rétroaction optique se produit de sorte que la fréquence de l'onde source est asservie sur celle du mode de résonance de la cavité optique résonante. Il en résulte un effet de rétrécissement spectral du spectre en fréquence de l'onde source qui se centre sur la fréquence d'un mode de résonance de la cavité optique résonante.

La rétroaction optique telle que décrite dans la demande de brevet précitée permet grâce au contrôle des caractéristiques spectrales de l'onde source émise par le laser, à la fois de la longueur d'onde d'émission du laser et de la largeur spectrale à cette longueur d'onde, d'optimiser l'injection des photons dans la cavité optique résonante et d'augmenter la sensibilité du système laser pour la détection des traces de gaz.

Cependant ces effets d'asservissement et de rétrécissement spectral ne se produisent qu'à certaines conditions. Il est nécessaire notamment que l'onde émergeant de la cavité optique résonante et renvoyée vers le laser soit en phase avec l'onde intra-cavité produite par le laser. Dans des montages tels que ceux décrits dans la demande de brevet précitée, cela implique que la distance entre le laser et la cavité optique résonante soit contrôlée avec une grande précision, puisque un déphasage apparaît si le trajet optique total d'un aller-retour laser / cavité n'est pas un multiple de la longueur d'onde de l'onde émise par le laser.

En outre, compte-tenu d'effets thermomécaniques ou de variation d'indice de l'air via la pression ou la température, ces conditions ne peuvent généralement être maintenues passivement que sur des temps limités, de l'ordre de quelques secondes.

De manière générale, la phase relative entre l'onde émergeant de la cavité optique résonante et l'onde source du laser est fonction de la longueur d'onde. La demande de brevet précitée exploite le fait qu'à une distance multiple de la longueur des bras de la cavité optique résonante, le champ électrique de l'onde résonante est nécessairement en phase avec celui du laser, quelle que soit la longueur d'onde : en effet, le champ électrique est nécessairement nul à la résonance sur les miroirs de fond de la cavité optique tout comme sur les miroirs de la cavité du laser. Par exemple, en plaçant le laser de telle sorte qu'il se situe, par rapport au miroir d'entrée de la cavité optique résonante, à une distance égale à la longueur du bras de la cavité optique qui n'est pas dans l'axe du laser, il est possible de faire varier la longueur d'onde d'émission du laser sans devoir rectifier la distance entre le laser et la cavité optique résonante. Il suffit alors d'utiliser un élément d'ajustement fin de la distance entre le laser et la cavité optique résonante. Cet élément est par exemple un miroir, monté sur un transducteur piézoélectrique, permettant un ajustement fin de la distance entre le laser et la cavité optique résonante. Un tel ajustement introduit cependant une limitation du fait notamment de la bande passante limitée du transducteur piézoélectrique et du temps nécessaire pour trouver la position du miroir permettant d'annuler la phase relative entre l'onde source et l'onde transmise en sortie de la cavité optique résonante.

En pratique, l'ensemble de ces contraintes fait que le réglage du système laser, dans un environnement donné, en vue de l'obtention de la rétroaction optique pour différentes fréquences d'émission laser, peut nécessiter plusieurs heures.

Il apparaît ainsi un besoin de s'affranchir de ces contraintes et/ou de simplifier les opérations de réglage du système laser.

### RESUME

La présente description a pour objet, selon un premier aspect, un système laser avec rétroaction optique. Ce système laser comprend :
- un laser, sensible à la rétroaction optique et destiné à émettre via une fibre optique de sortie une onde optique source, propagative, continue, ajustable en fréquence, dite onde source;
- une cavité optique résonante, couplée par rétroaction optique au laser, configurée pour générer une onde intra-cavité dont une fraction revient vers le laser sous forme d'une onde optique contra-propagative;
- un modulateur électro-optique fibré, placé sur le trajet optique entre le laser et la cavité optique résonante, le modulateur électro-optique étant configuré pour générer une onde source déphasée par déphasage de l'onde source et générer, par déphasage de l'onde optique contra-propagative, une onde contra-propagative déphasée, dite onde de contre-réaction, qui parvient au laser;
- un dispositif de contrôle de phase pour générer un signal de commande du modulateur électro-optique à partir d'un signal d'erreur représentatif de la phase relative entre l'onde source et l'onde de contre-réaction, de sorte à annuler la phase relative entre l'onde source et l'onde de contre-réaction.

La phase relative entre l'onde source et l'onde de contre-réaction est également appelée ici phase relative laser / cavité ou encore déphasage laser / cavité. La phase relative laser / cavité est notée Φ_{1c}. La phase relative laser / cavité Φ est déterminée modulo 2π, en valeur angulaire exprimée en radians. De même, l'ajustement de phase ΔΦ (ou déphasage) appliqué par le modulateur électro-optique est déterminé en valeur angulaire, exprimée en radians. Cet ajustement de phase ΔΦ correspond à l'ajustement total sur un trajet aller / retour laser / cavité de l'onde source, c'est-à-dire à la somme de l'ajustement de phase ΔΦ₁ produit sur l'onde source et de l'ajustement de phase ΔΦ₂ produit sur l'onde de contre-réaction. Cet ajustement de phase ΔΦ peut être inférieur, égal ou supérieur à 2π. Un ajustement de phase de ΔΦ = 2π (respectivement -2π) correspond à un allongement (respectivement raccourcissement) du chemin optique d'une longueur égale à la longueur d'onde λ de l'onde source. Plus généralement, un ajustement de phase de ΔΦ = 2π δ / λ correspond à un ajustement du chemin optique d'une longueur δ (positive ou négative).

Le modulateur électro-optique fibré est utilisé pour appliquer une correction de phase, plus précisément pour modifier la phase relative entre l'onde source et l'onde de contre-réaction. On s'affranchit en outre complètement de la contrainte sur la distance entre le laser et la cavité optique résonante du fait que le modulateur électro-optique dispose d'une plage de variation d'indice optique suffisante pour permettre un ajustement de phase pouvant être supérieur à une demi-longueur d'onde dans toute la gamme des longueurs d'onde d'une onde source laser. Cet ajustement de phase ΔΦ est appliqué à la fois sur l'onde source et sur l'onde contra-propagative, parvenant au modulateur électro-optique, à partir de laquelle est générée l'onde de contre-réaction. L'ajustement de phase, mesuré sur un aller-retour, peut donc correspondre à un allongement du chemin optique supérieur à une longueur d'onde λ de l'onde source. L'ajustement de phase ΔΦ appliqué par le modulateur électro-optique revient à ajuster (i.e. allonger ou raccourcir) le chemin optique de l'onde source de sorte que le déphasage laser / cavité soit nul modulo 2π, ce qui correspond à un chemin optique multiple entier de la longueur d'onde λ de l'onde source. Lorsque le déphasage laser / cavité est nul, le taux de couplage entre le laser et la cavité optique résonante est maximal et la transmission de la cavité optique résonante est également maximale.

Par ailleurs, en remplaçant l'élément mécanique d'ajustement de la distance entre le laser et la cavité optique résonante et le miroir par un modulateur électro-optique d'indice optique ajustable, configuré pour effectuer un ajustement de phase, on obtient une solution souple, simple et efficace pour l'ajustement quasi-instantané du déphasage laser / cavité. De plus, contrairement à la solution précitée qui procède par itération pour trouver la position du miroir permettant d'annuler le déphasage laser / cavité quelle que soit la longueur d'onde, la correction de phase générée au moyen du modulateur électro-optique permet de régler le déphasage laser / cavité en fonction de la longueur d'onde de l'onde optique source propagative. Le temps de réponse est inférieur à 0,1 nanoseconde (ns), bien inférieur au temps de réponse de quelques millisecondes (ms) nécessaire pour un ajustement mécanique d'un miroir. Plus encore, la correction de phase peut être appliquée quasi-instantanément à partir du signal d'erreur SE représentatif de la phase relative. De surcroît, l'ajustement de phase ΔΦ à appliquer peut être programmé informatiquement, à partir par exemple de mesures de la phase relative mémorisées pour différentes valeurs de longueurs d'onde, de sorte à augmenter encore la rapidité avec laquelle l'ajustement est effectué.

De surcroît, l'utilisation d'un laser avec sortie fibrée, constitue une avancée notable en ce qu'elle permet non seulement le remplacement rapide du laser, mais aussi l'insertion simple de modules optiques fibrés présentant des fonctions complémentaires, telles que la séparation de faisceau optique (« splitter » sur fibre optique ou circulateur optique sur fibre), le multiplexage séquentiel ou parallèle (switches optiques ou WDM, Wavelength de-multiplexer) de faisceaux lasers émettant à des longueurs d'ondes différentes, l'amplification de faisceau optique (amplificateur sur fibre, SOA ou BOA) pour le contrôle du taux de rétroaction optique ou de la puissance de sortie du système laser.

Dans au moins un mode de réalisation du système laser, la cavité optique résonante est formée par au moins deux miroirs dont au moins un miroir de sortie; et le dispositif de contrôle de phase est configuré pour générer le signal de commande du modulateur électro-optique à partir d'une fraction de l'onde intra-cavité qui sort de la cavité optique résonante via ledit miroir de sortie.

Dans au moins un mode de réalisation du système laser, la cavité optique résonante est formée par au moins deux miroirs dont un miroir d'entrée ;; et le dispositif de contrôle de phase est configuré pour générer le signal de commande du modulateur électro-optique à partir d'une onde résultant d'une interférence entre une fraction de l'onde source déphasée qui est réfléchie par le miroir d'entrée et une fraction de l'onde intra-cavité qui est transmise dans le sens contra-propagatif via le miroir d'entrée de la cavité optique résonante.

Dans au moins un mode de réalisation du système laser, le dispositif de contrôle de phase est configuré pour générer le signal de commande du modulateur électro-optique à partir d'une fraction de l'onde optique contra-propagative prélevée en entrée du modulateur électro-optique dans le sens contra-propagatif.

Dans au moins un mode de réalisation du système laser, le modulateur électro-optique est configuré en outre pour générer un signal optique modulé par modulation, en fonction du signal d'erreur, de la phase de l'onde source autour d'une valeur moyenne et le dispositif de contrôle de phase est configuré pour produire le signal de commande par une méthode de détection synchrone à partir d'une fraction de l'onde optique contra-propagative prélevée en entrée du modulateur électro-optique dans le sens contra-propagatif.

Dans au moins un mode de réalisation du système laser, la fibre optique de sortie est une fibre à maintien de polarisation.

Dans au moins un mode de réalisation du système laser, le laser est dépourvu d'isolateur optique en sortie.

Dans au moins un mode de réalisation, le système laser comprend au moins un composant optique fibré placé sur le trajet optique de l'onde source, avant ou après le modulateur électro-optique fibré, le composant optique fibré étant un composant dans le groupe constitué par un amplificateur optique, un coupleur optique, et un circulateur optique. De manière générale, ce composant optique fibré peut être un composant optique fibré agissant sur la phase, la fréquence et/ou l'amplitude des ondes propagatives et/ou contra-propagatives.

Dans au moins un mode de réalisation, le système laser selon la présente description est un système laser multi-sources, c'est-à-dire comprend au moins un deuxième laser configuré pour être couplé par rétroaction optique à la cavité optique résonante.

Dans au moins un premier mode de réalisation, le système laser comprend au moins un deuxième laser, sensible à la rétroaction optique et émettant via une fibre optique de sortie une deuxième onde optique source propagative, continue, ajustable en fréquence ; un commutateur optique fibré, configuré pour recevoir les ondes optiques sources propagatives en sortie du premier laser et dudit au moins un deuxième laser, pour sélectionner une des ondes optiques sources propagatives reçues et pour transférer au modulateur électro-optique fibré l'onde optique source propagative sélectionnée.

Dans au moins un deuxième mode de réalisation, le système laser comprend au moins un deuxième laser, sensible à la rétroaction optique et émettant via une fibre optique de sortie une deuxième onde optique source propagative, continue, ajustable en fréquence; au moins un deuxième modulateur électro-optique fibré, placé sur le trajet optique entre un dit deuxième laser correspondant et la cavité optique résonante, chaque dit deuxième modulateur électro-optique étant configuré pour générer une onde optique propagative déphasée par déphasage d'une dite deuxième onde optique source propagative correspondante; un multiplexeur optique fibré, configuré pour recevoir les ondes optiques propagatives déphasées en sortie du modulateur électro-optique et dudit au moins un deuxième modulateur électro-optique, pour générer une onde optique multiplexée par multiplexage fréquentiel des ondes optiques propagatives déphasées reçues, pour alimenter la cavité optique résonante avec l'onde multiplexée et pour générer des ondes démultiplexées en démultiplexant une fraction de l'onde intra-cavité qui parvient au multiplexeur sous forme d'une onde optique contra-propagative ; chaque dit deuxième modulateur électro-optique étant configuré en outre pour générer, par déphasage d'une des ondes démultiplexées, une onde optique contra-propagative correspondante qui parvient au deuxième laser correspondant; le dispositif de contrôle de phase étant configuré pour générer un signal de commande pour chaque deuxième modulateur électro-optique à partir d'un signal d'erreur représentatif de la phase relative entre une deuxième onde optique source propagative correspondante et l'onde optique contra-propagative correspondante parvenant au deuxième laser correspondant, de sorte à annuler la phase relative entre l'onde optique source propagative correspondante et l'onde optique contra-propagative correspondante. Dans au moins un mode de réalisation particulier, le système laser comprend en outre un composant optique pour générer une onde optique combinée par combinaison d'une fraction de l'onde source, respectivement de l'onde de contre-réaction, en sortie du laser et d'une fraction de la deuxième onde optique source propagative, respectivement de la deuxième onde optique contra-propagative, en sortie du deuxième laser.

Dans au moins un troisième mode de réalisation, le système laser comprend un deuxième laser, sensible à la rétroaction optique et émettant via une fibre optique de sortie une deuxième onde optique source propagative, continue, ajustable en fréquence; un deuxième modulateur électro-optique fibré, placé sur le trajet optique entre le deuxième laser et la cavité optique résonante, le deuxième modulateur électro-optique étant configuré pour générer une deuxième onde optique propagative déphasée par déphasage de la deuxième onde optique source propagative; un combinateur optique pour générer, à partir d'une première onde optique propagative déphasée générée par le modulateur électro-optique et de la deuxième onde optique propagative déphasée, une onde combinée comprenant deux ondes polarisées orthogonalement, pour alimenter la cavité optique résonante avec l'onde combinée et pour générer des ondes séparées en séparant, dans une fraction de l'onde intra-cavité qui parvient au combinateur optique sous forme d'une onde optique contra-propagative, les fractions d'ondes polarisées orthogonalement; le deuxième modulateur électro-optique étant configuré en outre pour déphaser une des ondes séparées et produire une deuxième onde optique contra-propagative qui parvient au deuxième laser ; le système laser comprenant en outre un deuxième dispositif de contrôle de phase pour générer un deuxième signal de commande du deuxième modulateur électro-optique à partir d'un deuxième signal d'erreur représentatif de la phase relative entre la deuxième onde optique source propagative et la deuxième onde optique contra-propagative, de sorte à annuler la phase relative entre la deuxième onde optique source déphasée propagative et la deuxième onde optique contra-propagative.

La présente description a pour objet, selon un deuxième aspect, un système de détection de gaz, comprenant un système laser selon la présente description, dans lequel la cavité optique résonante définit une enceinte destinée à recevoir au moins un gaz, le système de détection de gaz comprenant un dispositif d'analyse pour analyser au moins une onde optique générée par le système laser. Cette analyse peut être effectuée par exemple pour analyser les pertes introduites par le gaz, par exemple les pertes par absorption. Le spectre d'absorption du gaz présent dans la cavité peut être déterminé à partir d'une onde optique transmise en sortie de la cavité optique résonante. Une mesure de type CRDS (Cavity Ring Down Spectroscopy) peut également être réalisée à partir d'une onde optique transmise en sortie de la cavité optique résonante.

La présente description a pour objet, selon un troisième aspect, un procédé de génération d'onde optique comprenant : une génération d'une onde optique source propagative, continue, ajustable en fréquence, dite onde source, via une fibre optique de sortie d'un laser, sensible à la rétroaction optique; un couplage par rétroaction optique du laser avec une cavité optique résonante configurée pour générer une onde intra-cavité dont une fraction revient vers le laser sous forme d'une onde optique contra-propagative; une génération, par un modulateur électro-optique fibré placé sur le trajet optique de l'onde source entre le laser et la cavité optique résonante, d'une onde source déphasée par déphasage de l'onde source et, par déphasage de l'onde optique contra-propagative, d'une onde contra-propagative déphasée, dite onde de contre-réaction, qui parvient au laser; et une génération d'un signal de commande du modulateur électro-optique à partir d'un signal d'erreur représentatif de la phase relative entre l'onde source et l'onde de contre-réaction, de sorte à annuler la phase relative entre l'onde source et l'onde de contre-réaction.

### BREVE DESCRIPTION DES FIGS.

D'autres avantages et caractéristiques de la technique présentée ci-dessus apparaîtront à la lecture de la description détaillée ci-dessous, faite par référence aux Figs. dans lesquelles :
- la Fig. 1 illustre un mode de réalisation d'un système laser avec rétroaction optique;
- les Fig. 2A-2E illustrent différents modes de réalisation d'un système laser avec rétroaction optique utilisant différentes méthodes de génération d'un signal de commande du modulateur électro-optique;
- les Fig. 3A-3D illustrent différents aspects de la génération d'un signal de commande du modulateur électro-optique selon un ou plusieurs modes de réalisation;
- la Fig. 4 illustre un autre mode de réalisation d'un système laser avec rétroaction optique;
- la Fig. 5 illustre un mode de réalisation d'un système laser multi-sources avec rétroaction optique;
- la Fig. 6 illustre un autre mode de réalisation d'un système laser multi-sources avec rétroaction optique;
- la Fig. 7 illustre un autre mode de réalisation d'un système laser multi-sources avec rétroaction optique.

### DESCRIPTION DETAILLEE

Dans les différents modes de réalisation qui vont être décrits par référence aux Figs., des éléments semblables ou identiques portent les mêmes références.

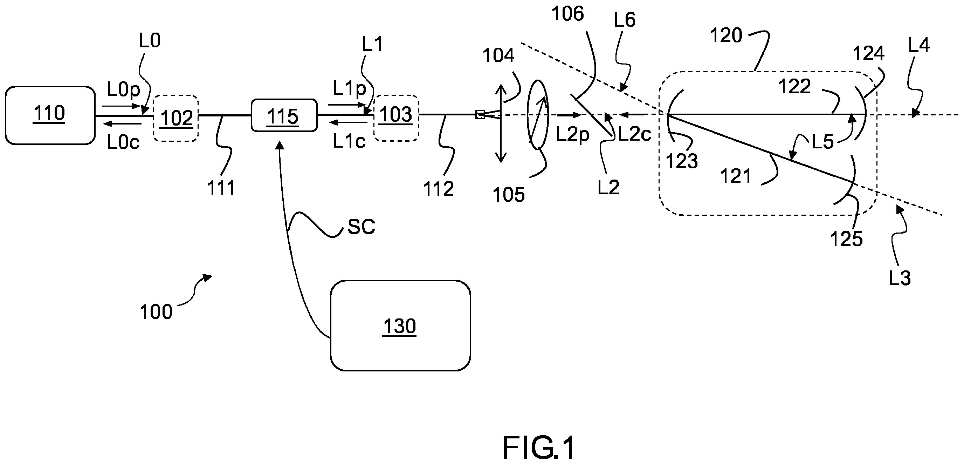

La Fig. 1 illustre de manière schématique un mode de réalisation d'un système laser 100 avec rétroaction optique. Différentes ondes optiques sont générées au sein du système laser 100. Dans le cadre de la présente description, une onde optique est dite propagative si elle se propage d'un laser vers une cavité optique résonante et contra-propagative dans le cas contraire.

Le système laser 100 comprend un laser 110, destiné à émettre via une fibre optique de sortie 111 une onde source propagative L0p, continue, ajustable en fréquence, appelée également onde source.

Le laser 110 est un laser sensible à la rétroaction optique, par exemple un laser à semiconducteur utilisé pour les télécommunications. Dans au moins un mode de réalisation, le laser 110 est dépourvu d'isolateur optique en sortie, de manière à augmenter la sensibilité du laser à la rétroaction optique.

Dans au moins un mode de réalisation, la fibre optique 111 de sortie du laser est une fibre à maintien de polarisation de sorte à stabiliser la polarisation de l'onde source. La fréquence de l'onde source L0p est typiquement ajustable sur une plage de 1 THz dans le cas des diodes utilisées pour les télécommunications, la fréquence centrale d'émission d'une diode particulière pouvant être comprise entre 176 et 240 THz.

Le système laser 100 comprend une cavité optique résonante 120, couplée par rétroaction optique au laser 110, configurée pour générer une onde intra-cavité L5. La cavité optique résonnante 120 comprend au moins un bras optique 121 limité par deux miroirs 123 et 124. Dans le mode de réalisation décrit par référence à la fig. 1, une configuration à deux bras 121, 122 sera décrite. Une telle configuration à deux bras ou plus simplifie la mise en œuvre. Dans l'exemple de la fig. 1, la cavité optique résonnante 120 est délimitée par trois miroirs 123, 124, 125. Les deux bras optiques 121, 122 formant un angle entre eux. Les deux bras 121, 122 ne sont pas nécessairement de longueurs identiques. Le bras optique 122 est le bras qui est délimité par le miroir de repliement 123 et le miroir de sortie 124. Le bras optique 121 est le bras qui est délimité par le miroir de repliement 123 et le miroir de sortie 125.

Selon les applications visées, la cavité optique résonnante 120 peut être vide ou remplie avec un gaz, un mélange de gaz, des aérosols, ou toute autre composition, par exemple un liquide si les miroirs sont adaptés.

Le système laser 100 comprend un modulateur électro-optique 115 fibré, placé sur le trajet optique de l'onde optique source propagative L0p, entre le laser 110 et la cavité optique résonante 120. Le modulateur électro-optique 115 est relié optiquement au laser 110 via la fibre optique 111 transmettant l'onde optique source propagative L0p.

Le modulateur électro-optique 115 est configuré pour ajuster et/ou moduler la phase de l'onde optique source propagative L0p et générer une onde optique propagative déphasée L1p par rapport l'onde optique source propagative L0p et/ou présentant des bandes latérales de modulation.

Le système laser 100 comprend en outre un dispositif de contrôle de phase 130 pour obtenir un signal d'erreur SE et générer un signal de commande SC du modulateur électro-optique 115 en fonction du signal d'erreur SE.

Une fibre optique 112, en sortie du modulateur électro-optique 115, transmet l'onde optique déphasée propagative L1p. Entre la fibre optique 112 et la cavité optique résonante 120, le trajet optique s'effectue en espace libre.

Une ou plusieurs lentilles 104 peuvent être placées en sortie de la fibre optique 112 afin de collimater l'onde optique déphasée propagative L1p sortant de la fibre optique 112 et de générer une onde optique propagative L2p dont la structure spatiale est adaptée à l'excitation d'un mode de résonance la cavité 120. L'onde optique propagative L2p est transmise en espace libre avant d'être injectée dans la cavité optique résonante 120. Une ou plusieurs lames séparatrices 106 peuvent être placées sur le trajet optique de l'onde optique propagative L2p afin de prélever une fraction de l'onde optique propagative L2p. Le bras optique 122 est aligné optiquement sur le trajet optique de l'onde optique propagative L2p.

Différentes ondes optiques sont ainsi générées au sein du système laser. Ces ondes optiques comprennent l'onde optique source L0 en sortie du laser 110, l'onde optique déphasée L1 en sortie du modulateur électro-optique 115, l'onde optique L2 en entrée de la cavité optique résonante 120, l'onde optique L3 en sortie de la cavité optique résonante 120, l'onde optique L4 en sortie de la cavité optique résonante 120, l'onde intra-cavité L5 et l'onde optique L6 en sortie de la cavité optique résonante 120.

L'onde intra-cavité L5 est une onde stationnaire résultant de la superposition de deux ondes de sens de propagation opposés : une onde propagative L5p se propageant du miroir de repliement 123 vers le miroir de sortie 125 ou 124 et une onde contra-propagative L5c se propageant du miroir de sortie 125 ou 124 vers le miroir de repliement 123. Une fraction de l'onde contra-propagative L5c sort de la cavité optique résonante et se propage vers le laser 110.

Lorsqu'une onde intra-cavité stationnaire L5 se forme dans la cavité optique résonante 120, l'onde optique contra-propagative L5c est réinjectée par trajet inverse dans le laser 110, donnant lieu au phénomène de rétroaction optique. Au fur et à mesure de ce trajet retour vers le laser 110 se propagent les ondes contra-propagatives L0c, L1c et L2c.

Ainsi, l'onde optique L2 en entrée de la cavité optique résonante 120 est composée d'une onde propagative L2p en sortie de la fibre optique 112 et d'une onde contra-propagative L2c. En particulier, l'onde contra-propagative L2c correspond à la fraction de l'onde optique contra-propagative L5c transmise au travers du miroir de repliement 123 dans l'axe du bras optique 122.

De même, l'onde optique L1 en sortie du modulateur électro-optique 115 est composée d'une onde propagative L1p générée par le modulateur électro-optique 115 et d'une onde contra-propagative L1c. De même, l'onde contra-propagative L1c correspond à la fraction de l'onde optique contra-propagative L5c qui parvient au modulateur électro-optique 115. L'action du modulateur électro-optique 115 étant identique dans les deux sens de propagation, il modifie autant, et de la même manière, la phase de l'onde source propagative L0p que la phase de l'onde contra-propagative L1c.

Le modulateur électro-optique modifie le chemin optique de l'onde incidente par changement de l'indice d'un matériau sous l'effet d'une tension électrique. L'ajustement de phase ΔΦ (ou déphasage) total produit par le modulateur électro-optique est donc double: un premier déphasage ΔΦ1 produit à l'aller sur l'onde propagative incidente et un deuxième déphasage ΔΦ2 = ΔΦ1 produit au retour sur l'onde contra-propagative incidente. L'ajustement de phase ΔΦ produit au total par le modulateur électro-optique est donc ΔΦ = ΔΦ1 + ΔΦ2 = 2 ^{∗} ΔΦ1 sur un trajet aller / retour laser / cavité de l'onde source. Ainsi il suffit que le modulateur électro-optique soit en mesure de produire un déphasage correspondant à un allongement / raccourcissement de chemin optique d'une demie longueur d'onde pour que le modulateur électro-optique puisse ajuster ce chemin optique à un multiple entier de la longueur d'onde de l'onde source L0p.

Enfin, l'onde optique L0 en sortie du laser 110 est composée d'une onde source propagative L0p générée par le laser 110 et d'une onde contra-propagative L0c qui parvient au laser 110. L'onde contra-propagative L0c correspond à la fraction de l'onde optique contra-propagative L5c qui parvient à la sortie du laser 110.

Chacune des ondes contra-propagatives L2c, L1c et L0c résultent ainsi de l'onde contra-propagative L5c.

L'onde optique L3, générée dans l'axe du bras 121 de la cavité optique résonante 120, résulte de la transmission d'une fraction de l'onde propagative L5p au travers du miroir de sortie 125. De même, l'onde optique L4, générée dans l'axe du bras 122 de la cavité optique résonante 120, résulte de la transmission d'une fraction de l'onde propagative L5p au travers du miroir de sortie 124. L'onde optique L6, générée dans l'axe du bras 121 de la cavité optique résonante 120 et selon un angle opposé à l'angle d'incidence de l'onde optique propagative L2p, résulte de la combinaison (interférence optique) d'une onde optique réfléchie L2r, résultant elle-même de la réflexion sur le miroir de repliement 123 de l'onde propagative L2p, et de la fraction de l'onde optique contra-propagative L5c transmission au travers du miroir de repliement 123 dans l'axe du bras optique 121.

Comme déjà indiqué plus haut, le déphasage entre l'onde contra-propagative L0c parvenant au laser 110 et l'onde source propagative L0p est appelé déphasage laser / cavité: ce déphasage correspond à un déphasage accumulé sur un trajet aller-retour laser / cavité complet par l'onde source propagative L0p. De même, le chemin optique aller-retour total entre le miroir de sortie de la cavité du laser et le miroir de repliement 123 de la cavité optique résonante 120 est appelé chemin optique laser / cavité.

Lorsque le déphasage laser / cavité est nul, la fraction de l'onde optique contra-propagative L5c transmise au travers du miroir de repliement 123 dans l'axe du bras optique 121 n'interfère pas avec l'onde propagative L2p, car l'onde propagative L2p est réfléchie avec un angle égal à celui des bras, ces deux ondes n'étant pas géométriquement superposées. A contrario, l'onde optique L6, résulte d'une interférence entre l'onde optique réfléchie L2r et la fraction de l'onde optique contra-propagative L5c transmise au travers du miroir de repliement 123 dans l'axe du bras optique 121.

Dans la cavité du laser 110, un champ stationnaire s'établit et résonne au sein de la cavité du laser 110. Ce champ interne au laser 110 est nécessairement nul au niveau des facettes de sortie de la cavité du laser 110. De la même manière, une onde optique stationnaire se développe dans la cavité optique résonante 120 et le champ électrique est nul sur les miroirs dits de "fond de cavité", c'est à dire les miroirs 125 et 124. L'onde optique intra-cavité qui est réfléchie sur le miroir 124 et revient vers le laser a un champ nécessairement nul à un point situé, par rapport au miroir 124, à une distance d121+d122, correspondant à la somme des longueurs des deux bras, ou encore à la distance d121 du miroir de repliement 123. Ce point fait partie des points, où, quelle que soit la fréquence de résonance excitée dans la cavité optique résonante, le champ est nul, puisque ce point correspond virtuellement (c'est-à-dire par effet "miroir") à un point équivalent au miroir 125 sur lequel le champ est nul à la résonance de la cavité optique résonante.

L'ajustement de la phase de l'onde optique source propagative L0p par le modulateur électro-optique 115 est effectué en fonction du signal d'erreur SE généré par le dispositif de contrôle de phase 130. Dans ce but, le dispositif de contrôle de phase 130 génère un signal de commande SC pour la commande du modulateur électro-optique 115 qui est fonction du signal d'erreur SE. Le signal d'erreur SE peut être généré à partir d'une ou de plusieurs des ondes optiques générées au sein du système laser.

Dans au moins un mode de réalisation, le signal d'erreur SE généré par le dispositif de contrôle de phase 130 est représentatif (modulo 2π) du déphasage laser / cavité et s'annule donc lorsque la phase relative laser / cavité est nulle. Le signal de commande SC du modulateur électro-optique 115 est déterminé sur la base du signal d'erreur SE de sorte à annuler la phase relative laser / cavité. L'ajustement de la phase de l'onde optique source propagative L0p par le modulateur électro-optique 115 est effectué en fonction du signal de commande SC ainsi produit.

L'ajustement de phase appliqué par le modulateur électro-optique 115 à l'onde optique L0p et L1c permet d'ajuster le chemin optique laser / cavité de sorte à annuler la phase relative laser / cavité. Dans au moins un mode de réalisation, une modulation de phase est en outre appliquée par le modulateur électro-optique 115 à l'onde source propagative L0p ou à l'onde déphasée propagative L1p de sorte à générer un signal d'erreur SE représentatif du déphasage laser / cavité et le signal de commande SC du modulateur électro-optique 115 qui permet d'annuler la phase relative laser / cavité.

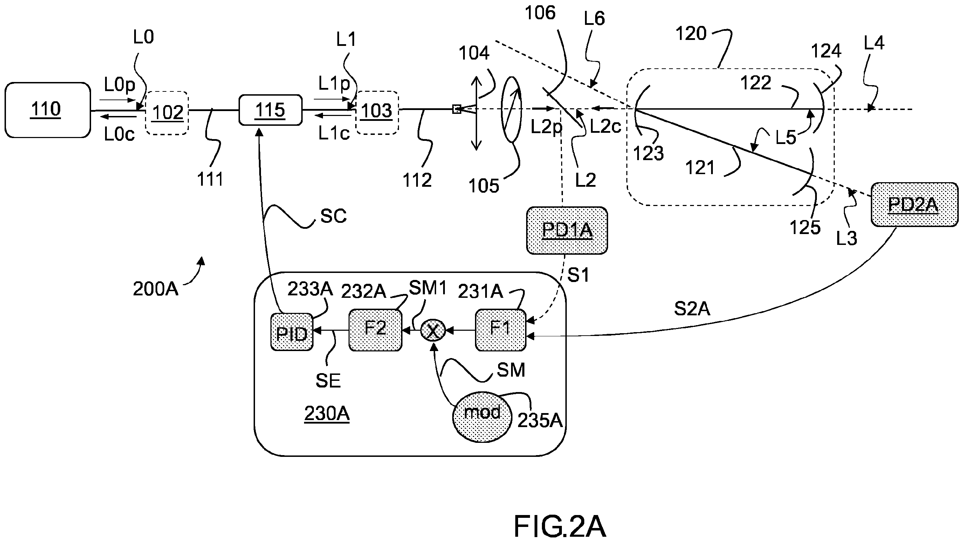

Le signal d'erreur SE peut être généré à partir d'une ou de plusieurs des ondes optiques générées au sein du système laser. Différents modes de réalisation sont décrits ci-dessous par référence aux Figs. 2A-2E.

De manière optionnelle, le système laser 100 peut comprendre un ou plusieurs polariseurs 105 placé sur le trajet en espace libre de l'onde optique L2 de manière par exemple à contrôler la polarisation de l'onde optique propagative L2p parvenant à la cavité optique résonante et/ou celle l'onde optique contra-propagative L2c de sorte à atténuer le taux de rétroaction de la cavité optique résonante 120 sur le laser 110.

De manière optionnelle, le système laser 100 peut comprendre un ou plusieurs composants optiques fibrés 102, 103, placés sur le trajet optique entre le laser 110 et la cavité optique résonante 120, avant ou après le modulateur électro-optique 115, c'est-à-dire placés sur la fibre optique 111 ou respectivement sur la fibre optique 112.

Le composant optique 103 est par exemple un circulateur optique fibré dont le taux d'isolation peut être modulé grâce au groupe polariseur 105 et configuré pour prélever, dans le sens contra-propagatif, une partie de l'onde optique contra-propagative propagative L2c afin d'en déterminer l'intensité. Dans au moins un mode de réalisation, le circulateur optique fibré est utilisé pour générer le signal d'erreur SE à l'aide d'une photodiode fibrée ou un signal d'absorption lorsque la cavité optique résonante 120 est remplie d'une substance à étudier.

Le composant optique 102 (respectivement 103) est par exemple un coupleur fibré configuré pour prélever, dans le sens propagatif, une partie de l'onde optique propagative L0p (respectivement de l'onde optique propagative L1p) afin, d'une part, d'évaluer l'intensité de cette onde propagative. ce qui est par exemple utile à la normalisation du signal de transmission de cavité L3, L4, L6 ou L2c dans le cas où la cavité optique résonante 120 sert à analyser la substance présente dans la cavité optique résonante 120 et d'autre part, à disposer, en vue d'autres applications, d'une partie du rayonnement dont les qualités spectrales sont grandement améliorées par l'effet de rétroaction optique. Le coupleur fibré 102 (respectivement103) peut également être utilisé pour prélever, dans le sens contra-propagatif, une partie de l'onde optique contra-propagative L1c (respectivement de l'onde optique contra-propagative L2c). Le prélèvement dans le sens contra-propagatif permet d'évaluer l'intensité de l'onde L2C provenant de la cavité optique résonante 120 et, par exemple, d'en extraire un signal d'erreur SE à l'aide d'une photodiode fibrée ou un signal d'absorption si la cavité optique résonante 120 est remplie d'une substance à étudier.

Le composant optique 102 (respectivement 103) est par exemple un amplificateur optique fibré permettant d'amplifier, dans le sens propagatif et contra-propagatif, l'onde optique source L0 (respectivement l'onde optique L1) afin de contrôler finement le taux de rétroaction optique par contrôle du gain d'amplification. Cela simplifie l'optimisation du taux de rétroaction entre le laser 110 et la cavité optique résonante 120 en particulier dans le cas d'une application à l'étude d'une substance placée dans la cavité optique résonante 120. Cela permet aussi de compenser les pertes induites par la présence éventuelle d'un isolateur optique dans le laser 110. Cela permet aussi d'utiliser très peu de photons du laser 110 en vue de la rétroaction optique et, grâce au composant optique 102 ou 103, d'en réserver la quasi-totalité pour d'autres applications.

La Fig. 2A illustre de manière schématique un mode de réalisation d'un système laser 100A avec rétroaction optique utilisant une première méthode de génération d'un signal de commande SC du modulateur électro-optique 115. Le système laser 200A comprend un laser 110, sensible à la rétroaction optique, une cavité optique résonante 120, une fibre optique 111, une fibre optique 112 et un modulateur électro-optique fibré 115, ces éléments étant identiques ou similaires à ceux décrits par référence à la Fig. 1 et reliés optiquement comme décrit à la Fig. 1. Le système laser 200A peut comprendre en outre les composants optiques 102, 103, 104, 105, 106 décrits par référence à la Fig. 1.

Le système laser 200A comprend en outre une photodiode PD1A pour générer, à partir d'une fraction de l'onde optique propagative L2p, prélevée par la lame séparatrice 106, un courant électrique dont l'intensité est fonction de l'intensité lumineuse de la fraction de l'onde optique propagative L2p.

Le système laser 200A comprend en outre une photodiode PD2A pour générer, à partir de l'onde optique L3, un courant électrique dont l'intensité est fonction de l'intensité lumineuse de l'onde optique L3.

Le système laser 200A comprend en outre un dispositif de contrôle de phase 230A configuré pour obtenir un signal d'erreur SE représentatif du déphasage laser / cavité et générer le signal de commande SC du modulateur électro-optique fibré 115 en fonction du signal d'erreur SE de sorte à annuler la phase relative laser / cavité. Le dispositif de contrôle de phase 230A est configuré pour générer le signal de commande SC à partir de l'onde optique L3 transmise via le miroir de sortie 125 et, optionnellement, de l'onde optique propagative L2p en entrée de la cavité optique résonante 120. Plus précisément, le signal de commande SC est généré à partir des signaux électriques générés par la photodiode PD2A, et, optionnellement, par la photodiode PD1A.

Le dispositif de contrôle de phase 230A comprend un filtre passe-bande 231A pour filtrer le signal généré par la photodiode PD2A pour effectuer un prétraitement visant à éliminer les fréquences en dehors de la bande 9-11 k Hz). Un signal de modulation SM est mélangé au signal en sortie du premier filtre passe-bande 231A pour générer un signal modulé SM1. Le signal de modulation SM est un signal à fréquence suffisamment basse, compte-tenu du fait que cette première méthode d'obtention du signal d'erreur SE est limitée par le temps de réponse de la cavité optique résonante 120. Le signal de modulation SM a une fréquence par exemple de 10 kHz et une amplitude de 1V. Un filtre passe-bas 232A est appliqué au signal modulé pour générer un signal d'erreur SE qui s'annule quand la transmission de la cavité optique résonante est maximale. La fréquence de coupure du filtre passe-bas est choisie inférieure à la fréquence de modulation, par exemple 1 kHz. Un correcteur PID 233A (proportionnel, intégrateur, dérivateur) permet ensuite de générer, à partir du signal d'erreur SE, le signal de commande SC du modulateur électro-optique 115. Optionnellement, le signal généré par la photodiode PD1A est utilisé pour normaliser le signal électrique généré par la photodiode PD2A avant que ce signal ne soit traité comme décrit ci-dessus afin de générer un signal de transmittance Tr représentatif des pertes de la cavité optique 120 induite par exemple par l'absorption d'un gaz dans la cavité optique résonante 120.

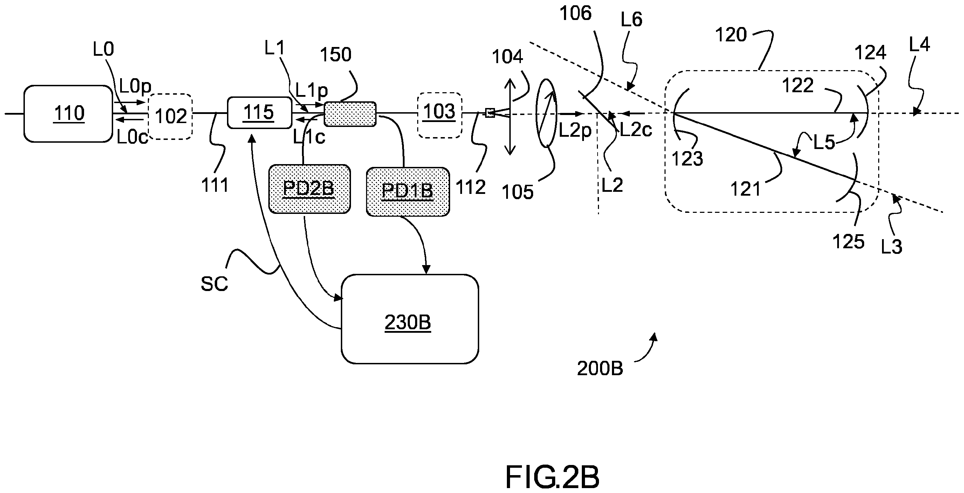

La Fig. 2B illustre de manière schématique un mode de réalisation d'un système laser 200B avec rétroaction optique utilisant une deuxième méthode de génération d'un signal de commande d'un modulateur électro-optique.

Le système laser 200B comprend un laser 110, sensible à la rétroaction optique, une cavité optique résonante 120, une fibre optique 111, une fibre optique 112 et un modulateur électro-optique fibré 115, ces éléments étant identiques ou similaires à ceux décrits par référence à la Fig. 1 et reliés optiquement comme décrit à la Fig. 1. Le système laser 200B peut comprendre en outre les composants optiques 102, 103, 104, 105, 106 décrits par référence à la Fig. 1.

Le système laser 200B comprend en outre un coupleur fibré 150 sur fibre pour prélever une fraction de l'onde optique L1 en sortie du modulateur électro-optique 115.

Le système laser 200B comprend en outre une photodiode PD1B en sortie du coupleur fibré150 pour générer, à partir d'une fraction de l'onde optique propagative L1p provenant du laser 110, un courant électrique dont l'intensité est fonction de l'intensité lumineuse de la fraction d'onde prélevée. La photodiode PD1B joue un rôle équivalent à celui joué par la photodiode PD1A décrite par référence à la fig. 2A en ce que les intensités des signaux optiques reçus par ces photodiodes sont proportionnelles.

Le système laser 200B comprend en outre une photodiode PD2B en sortie du coupleur fibré 150 pour générer, à partir d'une fraction de l'onde optique L1c provenant de la cavité optique résonante 120, un courant électrique dont l'intensité est fonction de l'intensité lumineuse de la fraction d'onde prélevée. De même, la photodiode PD2B joue un rôle équivalent à celui joué par la photodiode PD2A décrite par référence à la fig. 2A en ce que les intensités des signaux optiques reçus par ces photodiodes sont proportionnelles.

Le système laser 200B comprend en outre un dispositif de contrôle de phase 230B configuré pour obtenir un signal d'erreur SE représentatif du déphasage laser / cavité et générer le signal de commande SC du modulateur électro-optique fibré 115 en fonction du signal d'erreur SE de sorte à annuler la phase relative laser / cavité. Le dispositif de contrôle de phase 230B est configuré pour générer le signal de commande SC à partir de l'onde optique contra-propagative L1c, représentative de la fraction de l'onde contra-propagative L5c transmise via le miroir de repliement 123 et, optionnellement, de l'onde optique propagative L1p, représentative de l'onde propagative L2p en entrée de la cavité optique résonante 120. Plus précisément, le signal de commande SC est généré à partir des courants électriques générés par la photodiode PD2B, et, optionnellement, de par la photodiode PD1B.

Le principe de fonctionnement du dispositif de contrôle de phase 230B est identique à celui du dispositif de contrôle de phase 230A: le signal généré par la photodiode PD2B est utilisé, en lieu et place du signal généré par la photodiode PD2A, pour générer, comme décrit par référence à la Fig. 2A, le signal d'erreur SE et le signal de commande SC. Optionnellement, le signal généré par la photodiode PD1B est utilisé, en lieu et place du signal généré par la photodiode PD1A, pour normaliser le signal électrique généré par la photodiode PD2B avant que ce signal ne soit traité comme décrit par référence à la Fig. 2A.

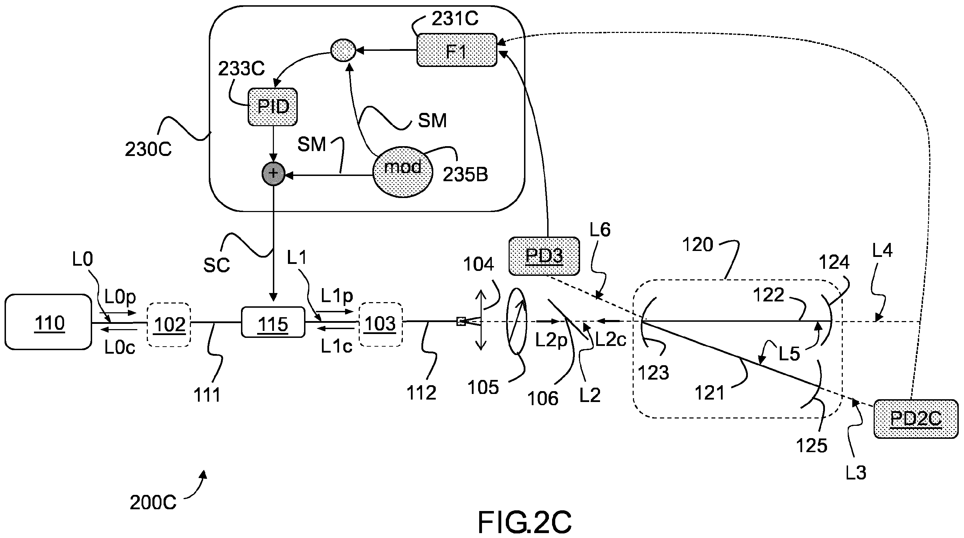

La Fig. 2C illustre de manière schématique un mode de réalisation d'un système laser 200C avec rétroaction optique utilisant une troisième méthode de génération d'un signal de commande du modulateur électro-optique. Le système laser 200C comprend un laser 110, sensible à la rétroaction optique, une cavité optique résonante 120, une fibre optique 111, une fibre optique 112 et un modulateur électro-optique fibré 115, ces éléments étant identiques ou similaires à ceux décrits par référence à la Fig. 1 et reliés optiquement comme décrit à la Fig. 1. Le système laser 200C peut comprendre en outre les composants optiques 102, 103, 104, 105, 106 décrits par référence à la Fig. 1.

Le système laser 200C comprend en outre une photodiode PD3 pour générer, à partir de l'onde optique L6, un courant électrique dont l'intensité est fonction de l'onde optique L6 résultant de l'interférence entre l'onde optique contra-propagative L5c et l'onde optique réfléchie L2r par le miroir de repliement 123.

Le système laser 200C peut comprendre en outre une photodiode PD2C pour générer, à partir de l'onde optique L3, un courant électrique dont l'intensité est fonction de l'intensité lumineuse de l'onde optique L3.

Le système laser 200C comprend en outre un dispositif de contrôle de phase 230C configuré pour obtenir un signal d'erreur SE représentatif modulo 2π du déphasage laser / cavité et générer le signal de commande SC du modulateur électro-optique fibré 115 en fonction du signal d'erreur SE de sorte à annuler la phase relative laser / cavité. Le dispositif de contrôle de phase 230C est configuré pour générer le signal de commande SC à partir de l'onde optique L6. Plus précisément, le dispositif de contrôle de phase 230A est configuré pour générer le signal de commande SC à partir du signal généré par la photodiode PD3.

Le principe de la méthode de génération du signal de commande SC consiste ici à mesurer la phase optique relative entre la fraction de l'onde intra-cavité L5 transmise via le miroir de repliement 123 de la cavité et l'onde optique source propagative L0p émise par le laser. L'onde optique L6 résultant du mélange de ces deux ondes est générée par la réflexion sur le miroir de repliement 123 de la cavité optique résonante 120. Le trajet optique de l'onde optique L6 est géométriquement distinct du trajet optique utilisé pour le couplage entre le laser 110 et la cavité optique résonante 120. On peut donc placer une photodiode PD3 sans perturber ce couplage.

Un signal de modulation SM est généré avec une fréquence de modulation de phase qui peut être choisie entre 100 kHz (soit environ 10 à 20 fois la largeur des modes de la cavité) et 10 GHz (cette limite étant fonction des possibilités de modulation du modulateur électro-optique 115 que l'on utilise). Le signal d'erreur SE est obtenu en appliquant un filtre passe-bande 231C au signal généré par la photodiode PD3, puis en modulant le signal filtré par le signal de modulation SM. Un correcteur PID 233C génère, à partir du signal d'erreur SE en entrée du correcteur PID, un signal de correction auquel est ajouté le signal de modulation SM de sorte à générer le signal de commande SC.

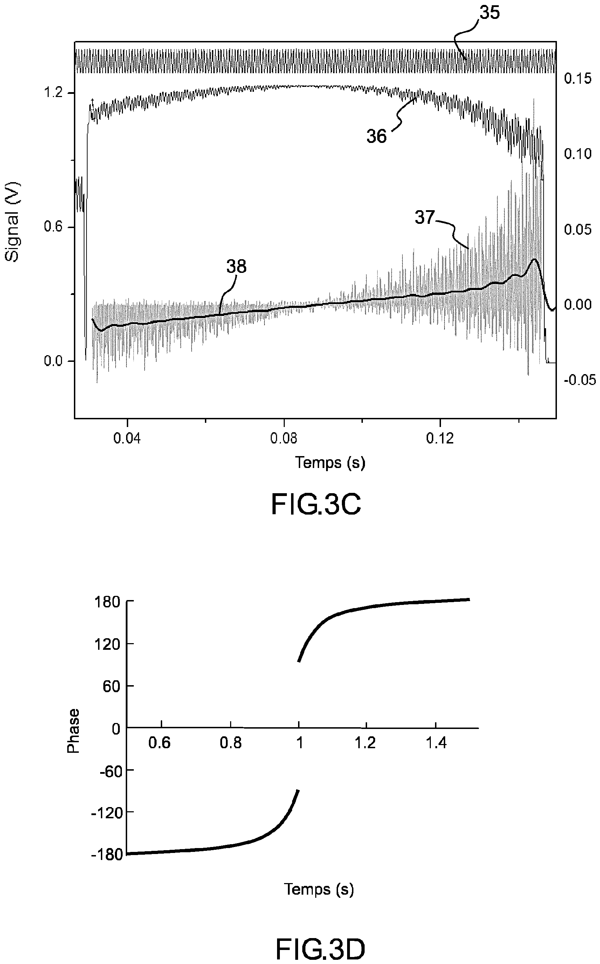

La phase relative entre la fraction de l'onde intra-cavité contra-propagative L5c transmise via le miroir de repliement 123 et l'onde optique source propagative L0p est fonction de l'écart par rapport à la résonance exacte, c'est-à-dire fonction du taux de couplage optimal entre le laser 110 et la cavité optique résonante 120. La Fig. 3D représente l'évolution de cette phase relative en fonction du désaccord avec la fréquence du laser source exprimé en fraction d'intervalle spectral libre de cavité optique résonante 120. Comme illustré par la Fig. 3D, cette phase relative passe d'un -π à +π et s'annule à la résonance exacte.

L'avantage principal de cette troisième méthode de génération du signal de commande, tient au fait que les photons stockés dans la cavité optique résonante 120, filtrés temporellement, constituent un réservoir très stable sur des échelles de plusieurs dizaines de micro secondes. La cavité optique résonante 120 agit comme une source de fréquence ultra-stable. Ainsi, toute action sur le laser 110 à une échelle de temps plus courte que celle du temps de réponse de la cavité sera détectée instantanément.

Puisqu'il est possible de mesurer très rapidement la phase relative, il est donc possible d'assurer un contrôle extrêmement rapide de la phase relative. On tire encore ici pleinement parti du modulateur électro-optique 115 qui permet un ajustement de phase quasi instantané, (temps de réponse <0.1ns).

Optionnellement, le signal généré par la photodiode PD2C est utilisé pour normaliser le signal électrique généré par la photodiode PD3 avant que ce signal ne soit traité comme décrit ci-dessus.

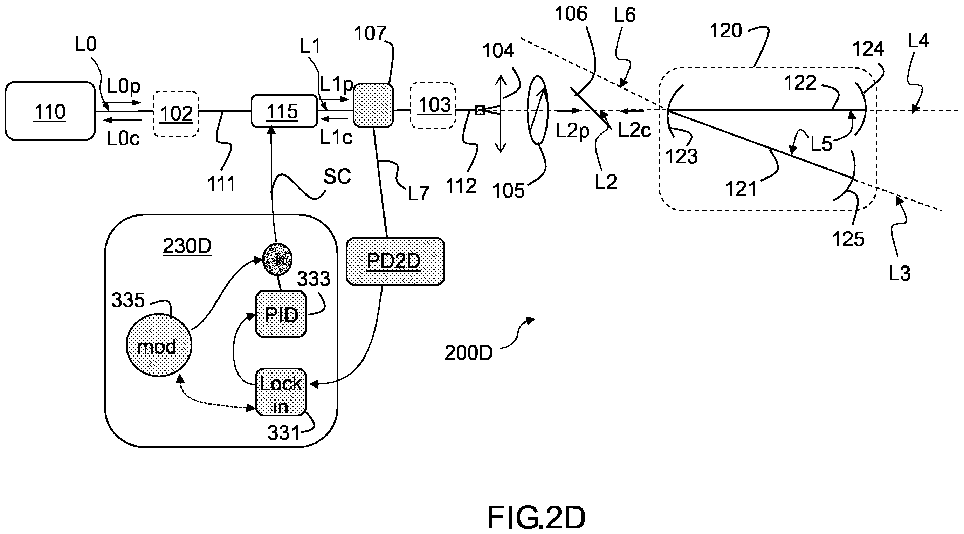

La Fig. 2D illustre de manière schématique un mode de réalisation d'un système laser 200D avec rétroaction optique utilisant une quatrième méthode de génération d'un signal de commande d'un modulateur électro-optique. Le système laser 200D comprend un laser 110, sensible à la rétroaction optique, une cavité optique résonante 120, une fibre optique 111, une fibre optique 112 et un modulateur électro-optique fibré 115, ces éléments étant identiques ou similaires à ceux décrits par référence à la Fig. 1 et reliés optiquement comme décrit à la Fig. 1. Le système laser 200D peut comprendre en outre les composants optiques 102, 103, 104, 105, 106 décrits par référence à la Fig. 1.

Le système laser 200D comprend en outre un coupleur fibré 107 pour prélever une partie de l'onde optique contra-propagative L1c dans la fibre optique 112 et générer une onde optique L7.

Le système laser 200D comprend en outre une photodiode PD2D pour générer, à partir de l'onde optique L7, un courant électrique dont l'intensité est fonction de l'intensité lumineuse de l'onde optique L7.

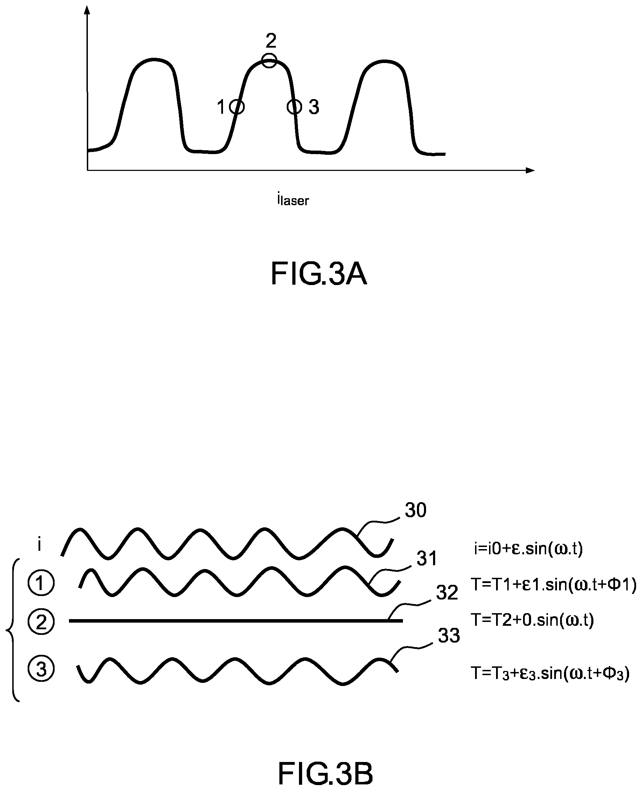

Le système laser 200D comprend en outre un dispositif de contrôle de phase 230D configuré pour obtenir un signal d'erreur SE représentatif du déphasage laser /cavité et générer le signal de commande SC du modulateur électro-optique fibré 115 en fonction du signal d'erreur SE de sorte à annuler la phase relative laser / cavité. Le dispositif de contrôle de phase 230D est configuré pour générer le signal de commande SC à partir de l'onde optique L1 en sortie du modulateur électro-optique 115. Plus précisément, le signal de commande SC est généré en fonction du signal d'erreur SE obtenu, par une méthode dite de détection synchrone, dans laquelle une modulation de phase est appliquée à l'onde optique source propagative L0p, cette modulation est appliquée autour d'une valeur moyenne. Le signal de commande SC est généré de sorte à appliquer un ajustement de la valeur moyenne de la phase à l'onde optique source propagative L0p, pendant que la modulation de phase est appliquée à cette même onde optique source propagative L0p.Cette modulation de phase induit une modulation d'intensité de l'onde intra-cavité L5 et donc de l'onde contra-propagative intra-cavité L5c. L'onde optique contra-propagative L1c étant représentative de l'onde optique contra-propagative L5c, cette modulation d'intensité est détectée par la photodiode PD2D à partir d'une fraction de l'onde optique contra-propagative L1c prélevée par le circulateur optique 107. Le signal d'erreur est obtenu par un amplificateur à détection synchrone 331 (« lock in amplifier ») par démodulation du signal généré par la photodiode PD2D. La méthode de détection synchrone est décrite plus en détail ci-dessous par référence aux Figs. 3A-3D.

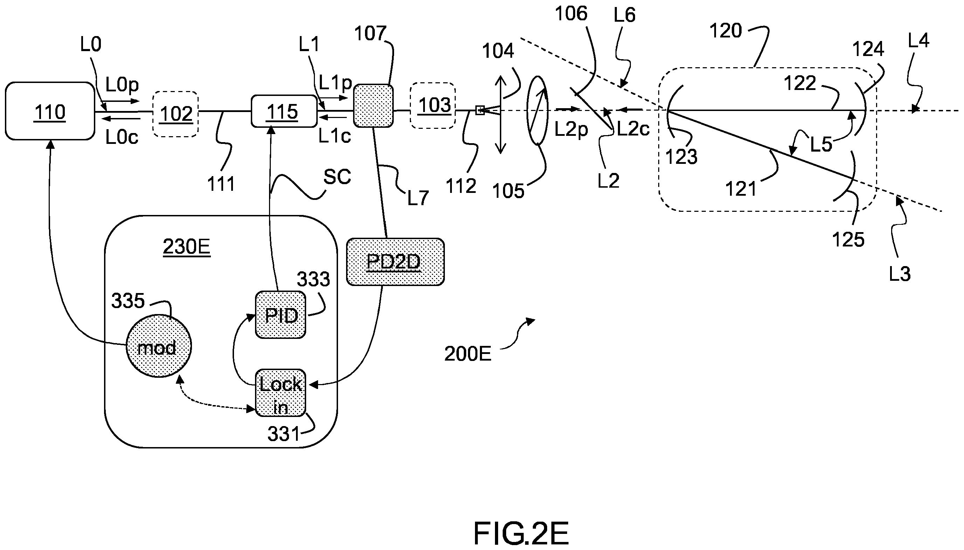

La Fig. 2E illustre de manière schématique un mode de réalisation d'un système laser 200E avec rétroaction optique utilisant une cinquième méthode de génération d'un signal de commande d'un modulateur électro-optique.

Le système laser 200E est identique au système laser 200D à la différence que le système laser 200E comprend un dispositif de contrôle de phase 230E configuré pour obtenir un signal d'erreur SE représentatif du déphasage laser / cavité et générer le signal de modulation SM du laser 110 et le signal de commande SC en fonction du signal d'erreur SE de sorte à annuler la phase relative laser / cavité. Le dispositif de contrôle de phase 230E est configuré pour générer le signal de commande SC à partir de l'onde optique L1 en sortie du modulateur électro-optique 115. Plus précisément, le signal de commande SC est généré par une méthode de détection synchrone, dans laquelle une modulation de l'intensité du courant alimentant la diode du laser 110 est générée pour induire une modulation de fréquence du laser. Celle-ci induit une modulation d'intensité de l'onde intra-cavité L5 et donc de l'onde contra-propagative intra-cavité L5c. L'onde optique contra-propagative L1c étant représentative de l'onde optique contra-propagative L5c, cette modulation d'intensité est détectée par la photodiode PD2D à partir d'une fraction de l'onde optique contra-propagative L1c prélevée par le circulateur optique 107. Le signal d'erreur SE est obtenu par un amplificateur à détection synchrone 331 (« lock in amplifier ») par démodulation du signal généré par la photodiode PD2D. Le signal de commande SC est généré de sorte à appliquer, en fonction du signal d'erreur SE obtenu, un ajustement à une valeur moyenne de la phase à l'onde optique source propagative L0p, pendant que la modulation de l'intensité du courant alimentant la diode du laser 110 est appliquée. La méthode de détection synchrone est décrite plus en détail ci-dessous par référence aux Figs. 3A-3D.

Les Figs 3A à 3D illustrent différents aspects de la génération du signal de commande SC du modulateur électro-optique 115 par une méthode de détection synchrone.

La Fig. 3A est une courbe de transmission représentant l'intensité de l'onde optique L3 ou L4 transmise par la cavité optique résonante 120 en fonction du temps lorsque l'on fait varier la fréquence de l'onde optique source propagative L0p. Cette variation de fréquence est obtenue par exemple en faisant varier l'intensité du courant Iₗₐₛₑᵣ alimentant la diode interne au laser 110. Lorsque le laser 110 s'accroche par rétroaction optique à l'une des fréquences de résonance de la cavité optique résonante 120, des photons sont efficacement injectés dans la cavité optique résonante 120 et s'y accumulent, ce qui conduit à une transmission d'ondes optiques L3, L2c, L4, ou L6 en sortie de la cavité optique résonante 120. A contrario, lorsque le laser 110 n'est pas accroché, les photons ne sont pas efficacement injectés et peu ou pas de lumière est transmise en sortie de la cavité optique résonante 120. L'efficacité du couplage entre le laser 110 et la cavité optique résonante 120 peut ainsi être mesurée par l'intensité d'une des ondes optiques L3, L2c, L1c, L4 ou L6 en sortie de la cavité optique résonante 120. Comme illustré à la Fig. 3A, cette intensité suit une sorte de courbe en cloche dont le sommet correspond à une situation de couplage optimal. En d'autres termes, l'optimisation du taux de couplage revient à maximiser l'intensité d'une des ondes optiques L3, L2c, L1c, L4, ou L6 en sortie de la cavité optique résonante 120.

Différents points de fonctionnement d'exemple (1), (2) et (3) de la courbe de transmission sont représentés à la Fig. 3A. Au point de fonctionnement (1), la dérivée de la courbe de transmission est positive : l'intensité de l'onde optique transmise augmente quand la fréquence de la source laser (i.e. du courant Iₗₐₛₑᵣ) augmente et diminue quand la fréquence de la source laser (i.e. du courant Iₗₐₛₑᵣ) diminue. Au point de fonctionnement 3), la dérivée de la courbe de transmission est négative : l'intensité de l'onde optique transmise diminue quand la fréquence de la source laser (i.e. du courant Iₗₐₛₑᵣ) augmente et augmente quand la fréquence de la source laser (i.e. du courant Iₗₐₛₑᵣ) diminue. Au point de fonctionnement (2), le taux de couplage est optimum et la dérivée de la courbe de transmission est nulle: l'intensité de l'onde optique transmise est inaffectée par le changement de fréquence de la source laser (i.e. du courant Iₗₐₛₑᵣ).

Les courbes de la Fig. 3B illustrent le comportement du système laser lorsque l'on applique un signal de modulation SM= εsin *ωt* de faible amplitude sur le courant Iₗₐₛₑᵣ. La courbe 30 représente le courant Iₗₐₛₑᵣ = *I*(*t*) + εsin *ωt* qui est appliqué à la diode du laser (ε > 0). La fréquence ω est par exemple de l'ordre de plusieurs kHz. La courbe 31 représente la courbe de transmission (essentiellement sinusoïdale) du laser obtenue autour du point de fonctionnement (1) avec une telle modulation : les parties croissantes de l'onde sinusoïdale ont une pente plus élevée en valeur absolue que les parties décroissantes de l'onde sinusoïdale, ce qui revient à une modulation de la phase Φ1 positive de la courbe de transmission Iₗₐₛₑᵣ = *I*(*t*) + ε1sin(*ωt* + Φ1). La courbe 32 représente la courbe de transmission du laser obtenue autour du point de fonctionnement (2) avec une telle modulation : la courbe de transmission est sensiblement constante (i.e. modulation de phase φ₂ nulle et d'amplitude ε₂ nulle avec Iₗₐₛₑᵣ = *I*(*t*) + ε2sin(*ωt* + Φ2)). La courbe 33 représente la courbe de transmission (essentiellement sinusoïdale) du laser obtenue autour du point de fonctionnement (3) avec une telle modulation : les parties croissantes de l'onde sinusoïdale ont une pente plus basse en valeur absolue que les parties décroissantes de l'onde sinusoïdale, ce qui revient à une modulation de la phase Φ3 négative de la courbe de transmission Iₗₐₛₑᵣ = *I*(*t*) + ε3sin(*ωt* + Φ3). On constate ainsi qu'il est possible détecter un grand nombre de fois par seconde la valeur de la dérivée de la courbe de transmission par rapport au courant et donc déterminer l'ajustement nécessaire pour obtenir un taux de couplage optimal entre le laser 110 et la cavité optique résonante 120.

Dans les modes de réalisation des Figs. 2D ou 2E, cette détection peut s'effectuer avec un amplificateur à détection synchrone 331 (« lock-in amplifier », selon la terminologie anglo-saxonne) qui permet en particulier de mesurer l'amplitude et la phase relative d'un signal (ici, le signal de transmission modulé) par rapport à un signal de référence sinusoïdal (ici, le signal de modulation SM de la fréquence d'émission du laser par modulation du courant électrique Iₗₐₛₑᵣ). Dans au moins un mode de réalisation de l'amplificateur à détection synchrone 331, le signal d'entrée est amplifié, puis multiplié par le signal de modulation pour générer le signal modulé. Puis un filtre passe-bas permet alors de réaliser une intégration du signal modulé.

Dans les modes de réalisation des 2D ou 2E, la sortie de l'amplificateur à détection synchrone 331 est reliée à un correcteur PID 333 (PID pour : proportionnel, intégrateur, dérivateur) qui permet de générer, à partir du signal d'erreur SE produit en sortie de l'amplificateur à détection synchrone 331, un signal de commande SC généré de sorte à annuler la phase relative laser / cavité.

Dans les modes de réalisation des Figs. 2A, 2C, 2D ou 2E, le correcteur PID 233A, 233C, 333 génère, à partir du signal d'erreur SE, en entrée de ce correcteur PID 233A, 233C, 333, un signal de commande SC qui est la somme pondérée de 3 composantes obtenues à partir du signal d'erreur SE : une composante proportionnelle correspondant au signal d'erreur SE, une composante intégrale obtenue par intégration du signal d'erreur SE et une composante dérivée obtenue par dérivation du signal d'erreur SE. La composante intégrale du signal de commande est utilisée pour filtrer les dérives lentes du signal d'erreur et la composante dérivée du signal de commande est utilisée pour filtrer les dérives rapides du signal d'erreur. Du fait de ces trois composantes, la stabilité du système peut ainsi être assurée.. Le signal de commande SC atteint, par le haut ou par le bas, une valeur optimale SM_{O} lorsque le signal d'erreur SE s'annule, c'est-à-dire quand la transmission de la cavité optique résonante est maximale et le taux de couplage laser / cavité est maximal. En outre le signal de commande peut continuer à augmenter ou diminuer pour suivre des variations de phase à compenser. Quand cette valeur optimale SM_{O} est atteinte, le modulateur électro-optique produit un ajustement de phase ΔΦ1 sur l'onde source issue du laser et un ajustement de phase total ΔΦ = ΔΦ1 + ΔΦ2 = 2 ^{∗} ΔΦ1 sur un trajet aller / retour laser / cavité de l'onde source. En outre, la composante proportionnelle du signal de commande SC augmente ou diminue, par rapport à la valeur optimale SM_{O}, en proportion par rapport à l'intensité du signal d'erreur SE.

Dans le mode de réalisation des Figs. 2C ou 2D, le signal de modulation SM est utilisé en outre pour moduler le signal de sortie du correcteur PID 233A, 233C, 333 de sorte à générer un signal de commande SC modulé qui est également la somme pondérée de 3 composantes obtenues à partir du signal d'erreur SE : une composante proportionnelle correspondant au signal d'erreur SE, une composante intégrale obtenue par intégration du signal d'erreur SE et une composante dérivée obtenue par dérivation du signal d'erreur SE. La valeur moyenne, autour de laquelle le signal de commande SC est modulé, atteint une valeur optimale lorsque le signal d'erreur SE s'annule (c'est-à-dire quand la transmission de la cavité optique résonante est maximale et le taux de couplage laser / cavité est maximal). En outre, la composante proportionnelle du signal de commande SC augmente ou diminue en proportion par rapport à l'intensité du signal d'erreur SE.

L'intensité de l'onde optique L3, L1c, L2c, L4, ou L6 en sortie de la cavité optique résonante 120 peut ainsi servir de signal d'entrée pour la génération d'un signal d'erreur SE représentatif du déphasage laser / cavité.

Pour une fréquence d'émission donnée du laser 110, le taux de couplage entre le laser 110 et la cavité optique résonante 120 peut être ajusté en ajustant la phase de l'onde optique propagative L1p en sortie du modulateur électro-optique 115 à une valeur moyenne telle que le chemin optique laser / cavité soit égal à un nombre entier de longueurs d'onde λ, où λ est la longueur d'onde de l'onde optique source propagative L0p.

Plutôt que de moduler la fréquence du laser 110, il est possible, comme représenté à la Fig. 2D, de moduler au moyen du modulateur électro-optique 115 la phase de l'onde optique L1 en sortie du modulateur électro-optique. Ceci permet de garder constant le courant de la diode du laser 110, c'est-à-dire de garantir une puissance d'émission stable du laser 110. Ceci permet, lorsqu'on prélève, par exemple au moyen d'un coupleur sur fibre, une fraction de l'onde optique source propagative L0p générée par le laser 110, d'obtenir une onde optique qui n'est pas perturbée par la modulation, tout en ayant un laser à la fois fin et stable en longueur d'onde et en puissance.

La Fig. 3C représente plusieurs signaux obtenus au moyen des systèmes laser 200D ou 200E. La courbe 35 (échelle à gauche de la courbe) représente un exemple de signal de modulation SM avec une fréquence de modulation à 1,4 kHz. La courbe 36 (échelle à gauche) représente une onde optique L3 ou L4 obtenue en sortie de la cavité optique résonante 120 en cas de modulation de l'intensité du courant Iₗₐₛₑᵣ alimentant la diode interne au laser 110. On observe que l'effet de la modulation s'annule au bout d'un temps environ égal à 0,09s correspondant au sommet de la courbe 36 où une valeur de 1,2V est atteinte : ce sommet correspond à un taux de couplage laser / cavité maximal. La courbe 37 (échelle à droite) représente le signal résultant de la modulation par le signal de modulation SM d'une onde optique L3 ou L4 en sortie de la cavité optique résonante 120. On observe également sur cette courbe 37 que l'effet de la modulation s'annule au bout d'un temps environ égal à 0,09s correspondant au sommet de la courbe 36. La courbe 38 (échelle à droite) est le signal d'erreur SE obtenu par filtrage passe-bas (par exemple avec une fréquence de coupure à 200Hz) du signal représenté par la courbe 37. Le signal de commande SC du modulateur électro-optique 115 est obtenu par application d'un correcteur PID au signal représenté par la courbe 38. La dérivée de la courbe 38 s'annule au bout d'un temps environ égal à 0,09s, pour une intensité moyenne d'environ 0,25 V, correspondant au sommet de la courbe 36 ou 37. Le signal de commande SC est ainsi généré de sorte qu'il atteint une valeur optimale quand la courbe 38 s'annule, et la composante proportionnelle du signal de commande SC augmente en proportion avec l'écart par rapport à l'intensité de la courbe 38 au point où la courbe 38 s'annule, c'est-à-dire au point correspondant au maximum de couplage laser / cavité et donc au maximum de transmission.

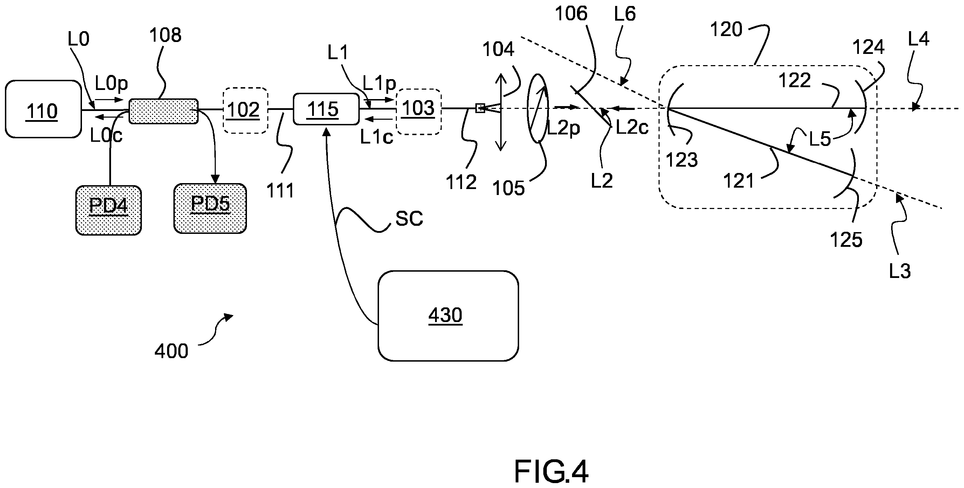

La Fig. 4 illustre de manière schématique un autre mode de réalisation d'un système laser 400 avec rétroaction optique. Ce mode de réalisation peut être combiné avec l'un quelconque des modes de réalisation décrits par référence aux Figs. 1, 2A à 2E.

Le système laser 400 comprend un laser 110, sensible à la rétroaction optique, une cavité optique résonante 120, une fibre optique 111, une fibre optique 112 et un modulateur électro-optique fibré 115, ces éléments étant identiques ou similaires à ceux décrits par référence à la Fig. 1 et reliés optiquement comme décrit à la Fig. 1. Le système laser 400 peut comprendre en outre les composants optiques 102, 103, 104, 105, 106 décrits par référence à la Fig. 1.

Le système laser 400 comprend en outre un dispositif de contrôle de phase 430 configuré pour obtenir un signal d'erreur SE représentatif modulo 2π du déphasage laser /cavité et générer le signal de commande SC du modulateur électro-optique fibré 115 en fonction du signal d'erreur SE de sorte à annuler la phase relative laser / cavité. Le signal de commande SC peut être généré selon l'une quelconque des méthodes décrites par référence aux Figs. 2A-2E.

Le système laser 400 comprend un coupleur 107 sur fibre pour prélever, une partie de l'onde optique source L0 en sortie du laser 110. Une photodiode PD4 est reliée une première sortie du coupleur 107 et reçoit une fraction (par exemple 10%) de l'onde optique source contra-propagative L0c qui revient au laser 110. Une photodiode PD5 est reliée une deuxième sortie du coupleur 107 et reçoit une fraction (par exemple 90%) de l'onde optique source propagative L0p qui part du laser. Le signal de sortie optique, visualisé sur la photodiode PD5 constitue une source optique ultra-stable et de forte puissance.

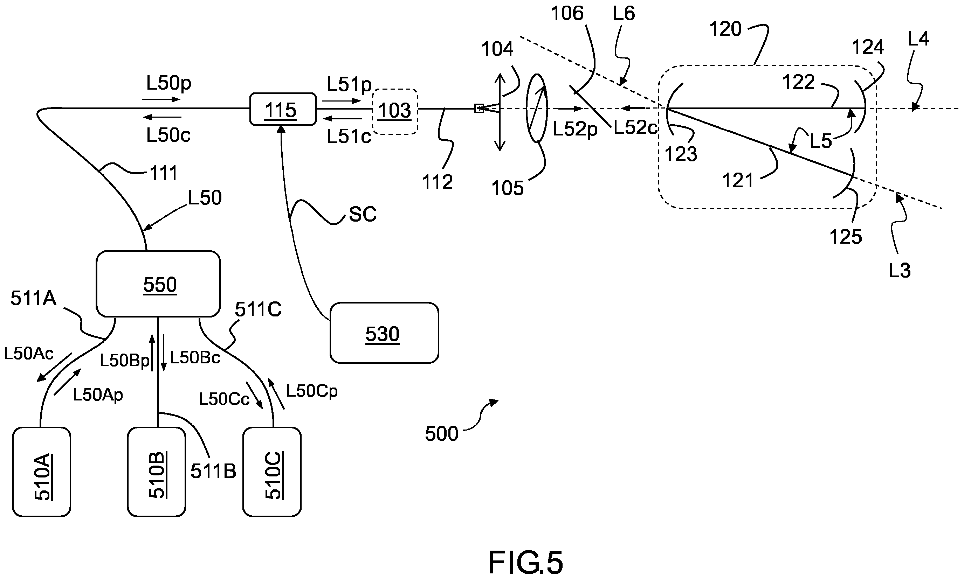

La Fig. 5 illustre de manière schématique un mode de réalisation d'un système laser 500 multi-sources avec rétroaction optique. Ce système laser 500 comprend au moins deux lasers, sensibles à la rétroaction optique et destinés à émettre via une fibre optique de sortie une onde optique source, continue, ajustable en fréquence. Dans l'exemple illustré à la Fig. 5, le système laser 500 comprend trois lasers (510A, 510B, 510C), sensibles à la rétroaction optique et destinés à émettre respectivement, via une fibre optique de sortie 511A à 511C correspondante, une onde optique source propagative (L50Ap, L50Bp, L50Cp) correspondante, continue, ajustable en fréquence. La description du mode de réalisation de la Fig. 5 est faite pour un nombre de lasers égal à 3 mais se généralise à un nombre quelconque de lasers.

Le système laser 500 comprend une cavité optique résonante 120, couplée par rétroaction optique avec l'un des lasers (510A, 510B, 510C), et configurée pour générer une onde intra-cavité L5. La cavité optique résonante 120 peut être identique ou similaire à la cavité optique résonante 120 décrite par référence à l'une quelconque des Figs. 1, 2A à 2E.

Le système laser 500 comprend en outre une fibre optique 111, une fibre optique 112 et un modulateur électro-optique fibré 115, ces éléments étant identiques ou similaires à ceux décrits par référence aux 1, 2A à 2E et reliés optiquement comme décrit dans ces figures. Le système laser 500 peut comprendre en outre les composants optiques 102, 103, 104, 105, 106 décrits par référence à la Fig. 1.

Le système laser 500 comprend en outre un commutateur optique 550 fibré, configuré pour recevoir les ondes optiques propagatives L50Ap-L50Cp en sortie respectivement des lasers 510A-510C, pour sélectionner une des ondes optiques reçues et pour transférer au modulateur électro-optique 115 l'onde optique propagative sélectionnée L50 via la fibre optique 111. L'onde optique sélectionnée L50p sert d'onde optique source propagative, le modulateur électro-optique 115 étant configuré pour ajuster (et optionnellement moduler) la phase de l'onde optique sélectionnée L50p comme décrit par référence aux Figs. 1, 2A à 2E de sorte à générer une onde optique propagative déphasée L51p par rapport l'onde optique source propagative L50p. En cas de modulation, l'onde optique propagative déphasée L51p présente en outre des bandes latérales de modulation. La rétroaction optique avec la cavité optique résonante 120 se produit donc pour le laser 510A à 510C ayant généré l'onde optique sélectionnée L50p.

L'onde optique intra-cavité stationnaire L5 qui se forme dans la cavité optique résonante 120 est composée d'une onde intra-cavité contra-propagative L5c et d'une onde intra-cavité propagative L5p. L'onde intra-cavité contra-propagative L5c est réinjectée par trajet inverse vers les lasers (510A, 510B 510C), donnant lieu au phénomène de rétroaction optique. La rétroaction optique peut se produire entre chacun des lasers (510A, 510B 510C) et la cavité optique résonante 120.

L'onde optique L52 en entrée de la cavité optique résonante 120 est ainsi composée d'une onde propagative L52p et d'une onde contra-propagative L52c. En particulier, l'onde contra-propagative L52c correspond à la fraction de l'onde intra-cavité contra-propagative L5c transmise au travers du miroir de repliement 123 dans l'axe du bras optique 122.

De même, l'onde optique L51 en sortie du modulateur électro-optique 115 est composée de l'onde propagative L51p et d'une onde contra-propagative L51c. L'onde contra-propagative L51c correspond à la fraction de l'onde intra-cavité contra-propagative L5c qui parvient à la sortie du modulateur électro-optique 115. L'action du modulateur électro-optique 115 étant identique dans les deux sens de propagation, il modifie autant, et de la même manière, la phase de l'onde source propagative L0p que la phase de l'onde contra-propagative L51c.

De même, l'onde optique L50 en sortie du commutateur optique 550 est composée de l'onde source propagative L50p, générée par le commutateur optique 550 comme décrit ci-dessus, et d'une onde contra-propagative L50c. L'onde contra-propagative L50c correspond à la fraction de l'onde optique contra-propagative L5c qui parvient à la sortie du commutateur optique 550.

Le commutateur optique 550 agit dans le sens contra-propagatif de sorte à réaliser la fonction inverse à celle réalisée dans le sens propagatif et génère ainsi une onde contra-propagative L50Ac, L50Bc, L50Cc renvoyée vers le laser 510A, 510B 510C dont l'onde source propagative a été sélectionnée par le commutateur optique 550 dans le sens propagatif.

Ainsi, l'onde optique L50A (respectivement L50B, L50C) en sortie du laser 510A (respectivement 510B, 510C) est composée de l'onde source propagative L50Ap (respectivement L50Bp, L50Cp) et d'une onde contra-propagative L50Ac (respectivement L50Bc, L50Cc).

Chacune des ondes contra-propagatives L52c, L51c, L50c, L50Ac, L50Bc, L50Cc, résultent ainsi de l'onde contra-propagative L5c.

Le système laser 500 comprend en outre un dispositif de contrôle de phase 530 configuré pour obtenir un signal d'erreur SE représentatif modulo 2π du déphasage laser / cavité accumulé sur le trajet aller-retour laser-cavité correspondant au laser 510A-510C ayant émis l'onde optique source propagative sélectionnée par le commutateur optique 550 et pour générer le signal de commande SC du modulateur électro-optique fibré 115 en fonction du signal d'erreur SE de sorte à annuler la phase relative laser / cavité correspondant au laser 510A-510C ayant émis l'onde optique source propagative sélectionnée. Le signal de commande SC peut être généré selon l'une quelconque des méthodes décrites par référence aux Figs. 1, 2A à 2E.

Les modes de réalisation décrits par référence à la Fig. 5 permettent une commutation rapide sur une des sources laser en vue, par exemple, de changer de canal de communication télécom ou de changer de plage spectrale dans le cadre d'analyse de l'absorption par la substance intra-cavité 120, c'est-à-dire, concrètement, pour concevoir des analyseurs multi-gaz à coût réduit avec une seule cavité optique résonante et plusieurs lasers sources.

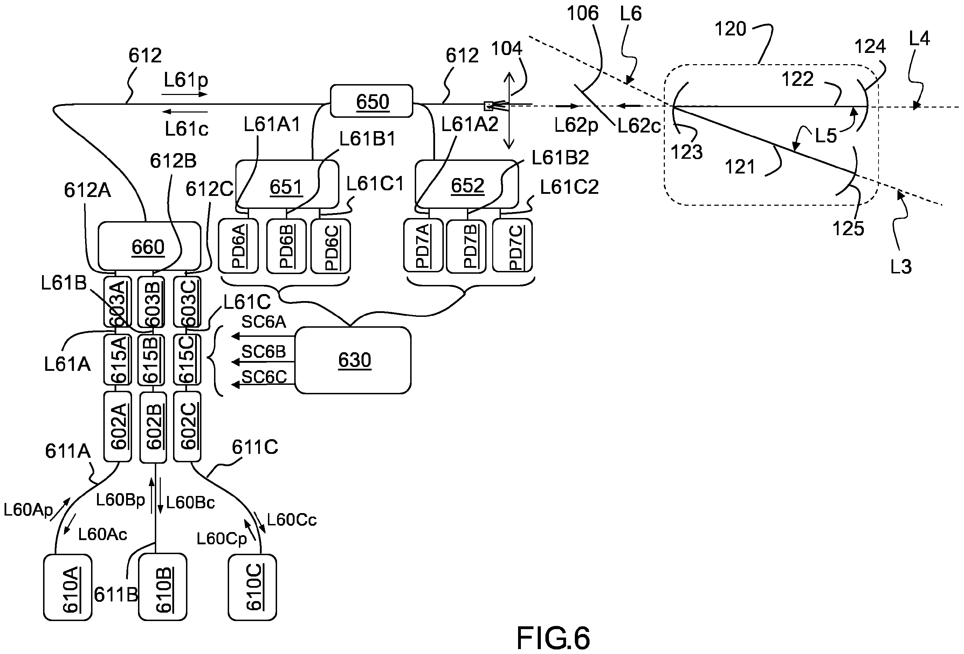

La Fig. 6 illustre de manière schématique un autre mode de réalisation d'un système laser 600 multi-sources avec rétroaction optique. Ce système laser 600 comprend au moins deux lasers, sensibles à la rétroaction optique et destinés à émettre via une fibre optique de sortie une onde optique source, continue, ajustable en fréquence. Dans l'exemple illustré à la Fig. 6, le système laser 600 comprend trois lasers (610A, 610B, 610C), sensibles à la rétroaction optique et destinés à émettre respectivement, via une fibre optique de sortie (611A, 611B, 611C) correspondante, une onde optique source propagative (L60Ap, L60B, L60C) correspondante, continue, ajustable en fréquence. La description du mode de réalisation de la Fig. 6 est faite pour un nombre de lasers égal à 3 mais se généralise à un nombre quelconque de lasers.

Chaque fibre optique (611A, 611B, 611C) est identique ou similaire à la fibre optique 111 décrite par référence à l'une quelconque des Figs. 1, 2A, 2B, 2C.

Le système laser 600 comprend une cavité optique résonante 120, couplée par rétroaction optique à chacun des lasers (610A, 610B 610C), et configurée pour générer une onde intra-cavité L5. La cavité optique résonante 120 peut être identique ou similaire à la cavité optique résonante 120 décrite par référence à l'une quelconque des Figs. 1, 2A, 2B, 2C.

Le système laser 600 comprend en outre, pour chaque laser (610A, 610B 610C), un modulateur électro-optique fibré (615A, 615B, 615C) correspondant, qui peut être identique ou similaire au modulateur électro-optique fibré 115 décrit par référence à l'une quelconque des Figs. 1, 2A, 2B, 2C.

Le système laser 600 comprend en outre, pour chaque modulateur électro-optique (615A, 615B, 615C), une fibre optique (612A, 612B, 612C) de sortie, identique ou similaire à la fibre optique 112 décrite par référence à l'une quelconque des Figs. 1, 2A, 2B, 2C.

Chacun des modulateurs électro-optiques (615A, 615B, 615C) est configuré pour ajuster (et optionnellement moduler) la phase de l'onde optique source propagative (L60Ap, L60Bp, L60Cp) correspondante, de sorte à générer une onde optique déphasée propagative (L61Ap, L61Bp, L61Cp) correspondante, de manière identique à ce qui a été décrit pour le modulateur électro optique 115 par référence à l'une quelconque des Figs. 1, 2A à 2E. En cas de modulation, l'onde optique propagative déphasée (L61Ap, L61Bp, L61Cp) présente en outre des bandes latérales de modulation.

Le système laser 600 comprend en outre un dispositif de contrôle de phase 630 pour générer un signal de commande (SC6A, SC6B, SC6C) pour chacun des modulateurs électro-optiques (615A, 615B, 615C). Chacun des signaux de commande (SC6A, SC6B, SC6C) est déterminé par le dispositif de contrôle de phase 630 de sorte à annuler, modulo 2π, le déphasage laser / cavité accumulé sur chacun des trajets aller-retour laser-cavité pour chaque laser (610A, 610B 610C).

Le système laser 600 comprend en outre, un multiplexeur 660 pour injecter dans la même fibre les ondes optiques propagatives déphasées (L61Ap, L61Bp, L61Cp) et générer une onde optique propagative multiplexée L61p via une fibre optique de sortie 612. Le multiplexage de longueurs d'onde (Wavelength De-Multiplexing, WDM) est effectué de sorte à ce que les bandes de fréquences des ondes optiques propagatives déphasées L61Ap-L61Cp puissent être respectivement multiplexées ou démultiplexées vers ou à partir d'une unique fibre. Dans au moins un mode de réalisation, ces bandes de fréquences sont des bandes disjointes.

Une ou plusieurs lentilles 104 peuvent être placées en sortie de la fibre optique 612 afin de collimater l'onde optique propagative L61p sortant de la fibre optique 612 et de générer une onde optique propagative L62p. L'onde optique propagative L62p est transmise en espace libre avant d'être injectée dans la cavité optique résonante 120. Une ou lames séparatrices 106 peuvent être placées sur le trajet optique de l'onde optique propagative L62p afin de prélever une fraction propagative de l'onde optique propagative L62.

L'onde optique intra-cavité stationnaire L5 qui se forme dans la cavité optique résonante 120 est composée d'une onde intra-cavité contra-propagative L5c et d'une onde intra-cavité propagative L5p. L'onde intra-cavité contra-propagative L5c est réinjectée par trajet inverse vers les lasers 610A- 610C, donnant lieu au phénomène de rétroaction optique. La rétroaction optique se produit entre chacun des lasers (610A, 610B 610C) et la cavité optique résonante 120.

Ainsi, l'onde optique L62 en entrée de la cavité optique résonante 120 est composée d'une onde propagative L62p et d'une onde contra-propagative L62c. En particulier, l'onde contra-propagative L62c correspond à la fraction de l'onde optique contra-propagative L5c transmise au travers du miroir de repliement 123 dans l'axe du bras optique 122.

De même, l'onde optique L61 en sortie du multiplexeur 660 est composée de l'onde propagative L61p, générée par le multiplexeur 660 comme décrit ci-dessus, et d'une onde contra-propagative L61c. L'onde contra-propagative L61c correspond à la fraction de l'onde optique contra-propagative L5c qui parvient à la sortie du multiplexeur 660.

Le multiplexeur 660 agit dans le sens contra-propagatif en démultiplexeur de sorte à séparer les composantes fréquentielles de l'onde contra-propagative L61c en réalisant la fonction inverse à celle réalisée dans le sens propagatif et génère ainsi les ondes contra-propagatives L61Ac, L61Bc, L61Cc.

Ainsi, l'onde optique L61A (respectivement L61B, L61C) en sortie du modulateur électro-optique 615A (respectivement 615B, 615C) est composée de l'onde déphasée propagative L61Ap (respectivement L61Bp, L61Cp) et d'une onde contra-propagative L61Ac (respectivement L61Bc, L61Cc). Le modulateur électro-optique 615A (respectivement 615B, 615C) est configuré pour, dans le sens propagatif, modifier la phase de l'onde source propagative L60Ap (respectivement L60Bp, L60Cp), et, dans le sens contra-propagatif modifier la phase de l'onde contra-propagative L61Ac (respectivement L61Bc, L61Cc). L'action du modulateur électro-optique 615A (respectivement 615B, 615C) étant identique dans les deux sens de propagation, il modifie autant, et de la même manière, la phase de l'onde source propagative L60Ap (respectivement L60Bp, L60Cp) que la phase de l'onde contra-propagative L61Ac (respectivement L61Bc, L61Cc).

L'onde optique L60A (respectivement L60B, L60C) en sortie du laser 610A (respectivement 610B, 610C) est composée de l'onde source propagative L60Ap (respectivement L60Bp, L60Cp) générée par le laser 610A (respectivement 610B, 610C) et d'une onde contra-propagative L60Ac (respectivement L60Bc, L60Cc) qui revient au laser 610A (respectivement 610B, 610C). L'onde contra-propagative L60Ac (respectivement L60Bc, L60Cc) correspond à la fraction de l'onde optique contra-propagative L5c qui parvient à la sortie du laser 610A (respectivement 610B, 610C).

Chacune des ondes contra-propagatives L62c, L61c, L61Ac, L61Bc, L61Cc, L60Ac, L60Bc, L60Cc résultent ainsi de l'onde contra-propagative L5c.

Le système laser 600 comprend en outre un coupleur 650 fibré, placé sur la fibre optique 612, configuré pour prélever dans le sens propagatif une partie de l'onde optique propagative L61p et dans le sens contra-propagatif une partie de l'onde optique contra-propagative L61c. Le coupleur 650 présente deux sorties fibrées, une première sortie fibrée 1 et une deuxième sortie fibrée 2.

Un multiplexeur 651 est placé sur la première sortie fibrée 1 du coupleur 650 de sorte à prélever dans le sens contra-propagatif les fractions L61A1, L61B1, L61C1 de l'onde optique contra-propagative L61c qui correspondent respectivement aux bandes de fréquence des ondes déphasées L61Ap, L61Bp, L61Cp en entrée du multiplexeur 660. Une photodiode PD6A, PD6B, PD6C correspondante est utilisée pour générer, à partir des ondes optiques L61A1, L61B1, L61C1 correspondantes, un courant électrique dont l'intensité est fonction de l'intensité lumineuse de l'onde optique correspondante. En alternative, les fractions L61A1, L61B1, L61C1 de l'onde onde optique multiplexée L61 peuvent être prélevées sur une des portions de fibre optique reliant un laser (610A, 610B 610C) au multiplexeur 660, par exemple en sortie des modulateurs électro-optiques (615A, 615B, 615C).

Un multiplexeur 652 est placé sur la deuxième sortie fibrée 2 du coupleur 650 de sorte à prélever dans le sens propagatif les fractions L61A2, L61B2, L61C2 de l'onde optique propagative L61p qui correspondent respectivement aux bandes de fréquence des ondes déphasées L61Ap, L61Bp, L61Cp en entrée du multiplexeur 660. Une photodiode PD7A, PD7B, PD7C correspondante est utilisée pour générer, à partir des ondes optiques L61A2, L61B2, L61C2 correspondantes, un courant électrique dont l'intensité est fonction de l'intensité lumineuse de l'onde optique L61A2, L61B2, L61C2 correspondante. En alternative, les fractions L61A2, L61B2, L61C2 de l'onde onde optique multiplexée L61 peuvent être prélevées sur une des portions de fibre optique reliant un laser (610A, 610B 610C) au multiplexeur 660, par exemple en sortie des modulateurs électro-optiques (615A, 615B, 615C).

Le dispositif de contrôle de phase 630 est configuré pour générer un signal d'erreur SE6A (respectivement SE6B, SE6C) représentatif, modulo 2π, du déphasage laser / cavité accumulé sur le trajet aller-retour laser-cavité correspondant au laser 610A (respectivement 610B, 610C) et générer le signal de commande SC6A (respectivement SC6B, SC6C) du modulateur électro-optique fibré 615A (respectivement 615B, 615C) en fonction du signal d'erreur SE6A (respectivement SE6B, SE6C) de sorte à annuler la phase relative laser / cavité correspondant au laser 610A (respectivement 610B, 610C). Le signal de commande SC6A (respectivement SC6B, SC6C) peut être généré selon la méthode décrite par référence à la fig. 2B, dans laquelle la photodiode PD7A (respectivement PD7B, PD7C) joue le rôle de la photodiode PD1B et la photodiode PD6A (respectivement PD6B, PD6C) joue le rôle de la photodiode PD2B.

Le système laser 600 peut comprendre en outre des composants optiques fibrés 602A à 602C (respectivement 603A à 603C), identiques au composant 102 (respectivement 103) décrit par référence à la Fig. 1, et placés avant ou après chacun des modulateurs électro-optiques (615A, 615B, 615C) correspondants.

Ce système permet d'utiliser une même cavité 120 pour rétroagir simultanément sur plusieurs lasers. Les instruments de détection de gaz peuvent alors analyser plusieurs régions spectrales en parallèle et en continu. On peut aussi disposer de plusieurs sources ultra-stables liées entre-elles via la cavité optique 120 pour des applications métrologiques, de télécommunication ou de combinaison (par exemple par battement optique, somme, différence) de fréquences très précises pour la génération de rayonnement térahertz par exemple.

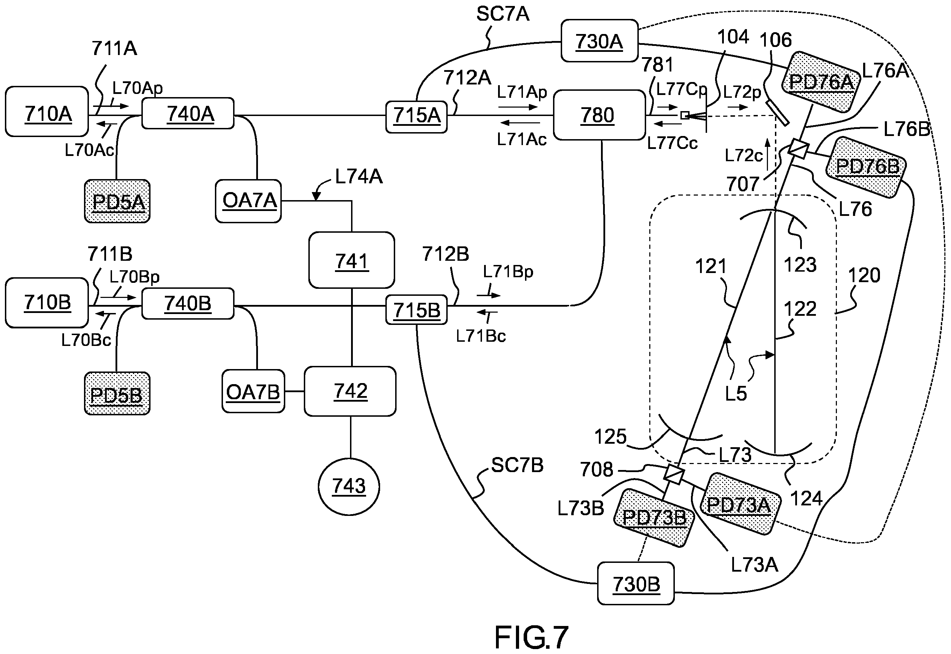

La Fig. 7 illustre de manière schématique un autre mode de réalisation d'un système laser 700 multi-sources avec rétroaction optique. Ce système laser 700 comprend au moins deux lasers, sensibles à la rétroaction optique et destinés à émettre via une fibre optique de sortie une onde optique source propagative, continue, ajustable en fréquence. Dans l'exemple illustré à la Fig. 7, le système laser 700 comprend deux lasers (710A, 710B), sensibles à la rétroaction optique et destinés à émettre respectivement, via une fibre optique de sortie (711A, 711B) correspondante, une onde optique source propagative (L70Ap, L70Bp) correspondante, continue, ajustable en fréquence.

Chaque fibre optique (711A, 711B) est identique ou similaire à la fibre optique 111 décrite par référence à la Fig. 1.

Le système laser 700 comprend une cavité optique résonante 120, couplée par rétroaction optique simultanément à chacun des lasers (710A, 710B), et configurée pour générer une onde intra-cavité L5. La cavité optique résonante 120 peut être identique ou similaire à la cavité optique résonante 120 décrite par référence à l'une quelconque des Figs. 1, 2A-2E.

Le système laser 700 comprend en outre, pour chaque laser (710A, 710B), un modulateur électro-optique fibré (715A, 715B) correspondant, qui peut être identique ou similaire au modulateur électro-optique fibré 115 décrit par référence à l'une quelconque des Figs. 1, 2A-2E.

Le système laser 700 comprend en outre, pour chaque modulateur électro-optique (715A, 715B), une fibre optique (712A, 712B) de sortie, identique ou similaire à la fibre optique 112 décrite par référence à l'une quelconque des Figs. 1, 2A-2E.

Chacun des modulateurs électro-optiques (715A, 715B) est configuré pour ajuster (et optionnellement moduler) la phase de l'onde optique source propagative (L70Ap, L70Bp) correspondante, et générer une onde optique déphasée propagative (L71Ap, L71Bp) correspondante, de manière identique ou similaire à ce qui a été décrit pour le modulateur électro optique 115 par référence à l'une quelconque des Figs. 1, 2A-2E. En cas de modulation, l'onde optique propagative déphasée (L71Ap, L71Bp) présente en outre des bandes latérales de modulation.

Le système laser 700 comprend en outre, un combinateur optique 780 pour, dans le sens propagatif, générer, à partir de la première onde optique propagative déphasée (L71Ap) et de la deuxième onde optique propagative déphasée (L71Bp), une onde propagative combinée (L77Cp) comprenant deux ondes polarisées orthogonalement (L77Ap, L77Bp). Dans un mode de réalisation, une première onde optique polarisée propagative (L77Ap) est obtenue par polarisation de la première onde optique déphasée propagative (L71Ap) et deuxième onde optique polarisée propagative (L77Bp) par polarisation, orthogonalement à la première onde optique polarisée propagative, de la deuxième onde optique déphasée propagative (L71Bp). Par exemple, des fibres optiques à maintien de polarisation sont utilisées en sortie des modulateurs électro-optiques 715A et 715B, ces fibres étant reliées à l'entrée du combinateur optique (780) de sorte que leurs axes de polarisation soient orthogonaux. Le combinateur optique (780) est en outre configuré pour alimenter la cavité optique résonante avec l'onde propagative combinée (L77Cp) obtenue.

Une ou plusieurs lentilles 704 peuvent être placées en sortie de la fibre optique 781 afin de collimater l'onde optique propagative L77Cp sortant de la fibre optique 781 et de générer une onde optique propagative L72p. Tout comme l'onde optique propagative L77Cp, l'onde optique propagative L72p comprend deux ondes optiques de polarisations orthogonales. L'onde optique propagative L72p est transmise en espace libre avant d'être injectée dans la cavité optique résonante 120.

Un ou plusieurs miroirs 706 peuvent être placés sur le trajet optique de l'onde optique propagative L72p afin de diriger l'onde optique L72p vers l'entrée de la cavité optique résonante 120.

Une onde intra-cavité stationnaire L5 se forme dans la cavité optique résonante 120 comprend deux ondes optiques de polarisations orthogonales, correspondant aux polarisations des ondes optiques L77Ap, L77Bp combinées dans l'onde optique combinée propagative L77Cp. De même, l'onde intra-cavité propagative L5p, tout comme l'onde intra-cavité contra-propagative L5p, comprend deux ondes optiques de polarisations orthogonales, correspondant aux polarisations des ondes optiques L77Ap, L77Bp combinées dans l'onde optique combinée propagative L77Cp.

En outre, lorsque l'onde intra-cavité stationnaire L5 se forme dans la cavité optique résonante 120, l'onde optique contra-propagative L5c est réinjectée par trajet inverse vers les lasers 710A, 710B, donnant lieu au phénomène de rétroaction optique. La rétroaction optique se produit entre chacun des lasers (710A, 710B) et la cavité optique résonante 120.

Ainsi, l'onde optique L72 en entrée de la cavité optique résonante 120 est composée d'une onde propagative L72p et d'une onde contra-propagative L72c. En particulier, l'onde contra-propagative L72c correspond à la fraction de l'onde optique contra-propagative L5c transmise au travers du miroir de repliement 123 dans l'axe du bras optique 122. Tout comme l'onde propagative L72p, l'onde onde contra-propagative L72c comprend deux ondes optiques de polarisations orthogonales, correspondant aux polarisations des ondes optiques L77Ap, L77Bp combinées dans l'onde optique combinée propagative L77Cp.

De même, l'onde optique L77C en sortie du combinateur optique 780 est composée de l'onde propagative L77Cp et d'une onde contra-propagative L77Cc. Tout comme l'onde propagative L77Cp, l'onde onde contra-propagative L77Cc comprend deux ondes optiques contra-propagatives L77Ac, L77Bc de polarisations orthogonales, correspondant aux polarisations des ondes optiques L77Ap, L77Bp Dans le sens contra-propagatif, le combinateur optique 780 est configuré pour générer des ondes séparées en séparant, dans l'onde optique combinée contra-propagative L77Cc qui parvient au combinateur optique, les fractions d'ondes polarisées orthogonalement et générer les ondes contra-propagatives L71Ac et L71Bc.

De même, l'onde optique L71A (respectivement L71B) en sortie du modulateur électro-optique 715A (respectivement 715B) est composée de l'onde déphasée propagative L71Ap (respectivement L71Bp) et d'une onde contra-propagative L71Ac (respectivement L71Bc). Le modulateur électro-optique 715A (respectivement 715B) est configuré pour, dans le sens propagatif, modifier la phase de l'onde source propagative L70Ap (respectivement L70Bp) et pour, dans le sens contra-propagatif, modifier la phase de l'onde contra-propagative L71Ac (respectivement L71Bc). L'action du modulateur électro-optique 715A (respectivement 715B) étant identique dans les deux sens de propagation, il modifie de la même manière la phase de l'onde source propagative L70Ap (respectivement L70Bp) que la phase de l'onde contra-propagative L71Ac (respectivement L71Bc).

De même, l'onde optique L70A (respectivement L70B) en sortie du laser 710A (respectivement 710B) est composée de l'onde source propagative L70Ap (respectivement L70Bp) générée par le laser 710A (respectivement 710B) et d'une onde contra-propagative L70Ac (respectivement L70Bc) qui revient au laser 710A (respectivement 710B). L'onde contra-propagative L70Ac (respectivement L70Bc) correspond à la fraction de l'onde optique contra-propagative L5c qui parvient au laser 710A (respectivement 710B).

Chacune des ondes contra-propagatives L72c, L77Cc, L71Ac, L71Bc, L70Ac, L70Bc résultent ainsi de l'onde contra-propagative L5c.

Le système laser 700 comprend en outre, un séparateur de faisceau 707 placé en entrée de la cavité optique résonante, dans l'axe du bras 121 de la cavité optique. Le séparateur de faisceau 707 reçoit l'onde optique L76. Une onde optique réfléchie L72r résulte de la réflexion sur le miroir de repliement 123 de l'onde optique propagative L72p. En fonctionnement, lorsqu'une onde stationnaire intra-cavité L5 se forme dans la cavité optique résonante 120, l'onde optique L76, formée en entrée de la cavité 120 dans l'axe optique du bras 121, résulte d'une interférence optique entre l'onde optique réfléchie L72r et une fraction de l'onde intra-cavité contra-propagative L5c, transmise via le miroir de repliement 123 de la cavité optique résonante 120 dans l'axe du bras 121 de la cavité optique résonante. A contrario, pour la fraction de l'onde optique contra-propagative L5c, transmise via le miroir de repliement 123, dans l'axe du bras 122 de la cavité optique résonante 120, il n'y a pas d'interférence avec l'onde optique propagative L72p. Le séparateur de faisceau 707 génère, à partir de l'onde optique L76, deux ondes optiques L76A, L76B de polarisations distinctes, correspondant respectivement aux polarisations de la première onde optique polarisée L77Ap et la deuxième onde optique polarisée L77Bp.

Le système laser 700 comprend en outre une photodiode PD76A pour générer, à partir de l'onde optique L76A, un courant électrique dont l'intensité est fonction de l'intensité lumineuse de l'onde optique L76A.

Le système laser 700 comprend en outre une photodiode PD76B pour générer, à partir de l'onde optique L76B, un courant électrique dont l'intensité est fonction de l'intensité lumineuse de l'onde optique L76B.

Le système laser 700 peut comprendre en outre, un séparateur de faisceau 708 placé en sortie de la cavité optique résonante, dans l'axe du bras 121 de la cavité optique. Le séparateur de faisceau 708 reçoit l'onde optique L73 qui résulte de la transmission d'une fraction de l'onde intra-cavité propagative L5 via le miroir de sortie 125 de la cavité optique résonante 120. Le séparateur de faisceau 708 génère, à partir de l'onde optique L73, deux ondes optiques L73A, L73B de polarisations distinctes, correspondant respectivement aux polarisations de la première onde optique polarisée L77Ap et la deuxième onde optique polarisée L77Bp.

Le système laser 700 peut comprendre en outre une photodiode PD73A pour générer, à partir de l'onde optique L73A, un courant électrique dont l'intensité est fonction de l'intensité lumineuse de l'onde optique L73A.

Le système laser 700 peut comprendre en outre une photodiode PD73B pour générer, à partir de l'onde optique L73B un courant électrique dont l'intensité est fonction de l'intensité lumineuse de l'onde optique L73B.

Le système laser 700 comprend en outre un ou plusieurs dispositifs de contrôle de phase (730A, 730B) pour générer un signal de commande (SC7A, SC7B) pour chacun des modulateurs électro-optiques (715A, 715B). Chacun des signaux de commande (SC7A, SC7B) déterminé par un dispositif de contrôle de phase (730A, 730B) de sorte à annuler, modulo 2π, le déphasage laser / cavité accumulé sur le trajet aller-retour laser-cavité correspondant à chaque laser (710A, 710B). Chacun des dispositifs de contrôle de phase (730A, 730B) reçoit le courant électrique généré par les photodiodes PD76A, PD76B (et optionnellement PD73A, PD73B) qui reçoivent une onde optique de polarisation correspondante à celle de l'onde optique déphasée concernée.

Le signal de commande SC7A (respectivement SC7B) est généré à partir du signal d'erreur correspondant SE7A (respectivement SE7B), ce signal d'erreur SE7A étant obtenu à partir du signal électrique généré respectivement par la photodiode PD76A (respectivement PD76B), et, optionnellement, du signal électrique généré respectivement par la photodiode PD73A (respectivement PD73B), selon la méthode décrite par référence à la Fig. 2C, dans laquelle la photodiode PD76A (respectivement PD76B) joue le rôle de la photodiode PD3 et la photodiode PD73A (respectivement PD73B) joue le rôle de la photodiode PD2C de sorte à générer le signal de commande SC7A (respectivement SC7B).

Le système laser 700 peut comprendre en outre un coupleur 740A fibré, placé sur la fibre optique 711A, configuré pour prélever une partie de l'onde optique propagative L70Ap. Le coupleur 740A présente au moins une sortie sur laquelle peut être placé un amplificateur optique OA7A pour générer une onde optique de sortie L74A à puissance élevée.

Dans au moins un mode de réalisation le système laser 700 comprend un composant optique pour combiner les ondes optiques propagatives L70Ap, L70Bp (respectivement contra-propagatives L70Ac, L70Bc) en sortie des lasers 710A et 710B. Une fraction de ces ondes optiques propagatives L70Ap, L70Bp (respectivement contra-propagatives L70Ac, L70Bc) est alors prélevée, par exemple par coupleur optique ou circulateur optique. Par exemple, le système laser 700 peut comprendre en outre un coupleur 740B fibré, placé sur la fibre optique 711B, configuré pour prélever une partie de l'onde optique L70B. Le coupleur 740B présente au moins une sortie sur laquelle peut être placé un amplificateur optique OA7B pour générer une onde optique de sortie L74B à puissance élevée. L'onde optique de sortie L74A et l'onde optique de sortie L74B sont stables en fréquence, et de bande spectrale très étroite, par exemple quelques Hz, soit une précision relative de 10⁻¹⁴. Le système laser 700 peut par exemple comprendre en outre un composant optique pour combiner, par exemple par battement optique, somme ou différence, l'onde optique de sortie L74A et l'onde optique de sortie L74B, de sorte à obtenir une onde optique à plus haute ou plus basse fréquence, stable en fréquence et de haute précision.

Une application possible du système 700 est ainsi la génération de deux ondes optiques dont le rapport de fréquence est très précis en vue de générer, par exemple, un rayonnement THz très pur et largement accordable. Le système 700 trouve ainsi applications pour la détection de molécules lourdes: biologie, explosifs, imagerie, télécommunications, etc...

Les différents systèmes laser décrits ici par référence aux Figs. 1 à 7 sont utilisables pour la réalisation d'un système de détection de gaz. Dans un tel système de détection de gaz, la cavité optique résonante définit une enceinte destinée à recevoir au moins un gaz à analyser. Le système de détection de gaz peut comprendre un dispositif d'analyse pour analyser et/ou comparer une ou plusieurs ondes optiques produites par le système laser. Par exemple le dispositif d'analyse est configuré pour déterminer un rapport entre les intensités lumineuses d'une onde optique en sortie de la cavité optique résonante et d'une onde optique en entrée de la cavité optique résonante. Dans au moins un mode de réalisation, on fait varier la fréquence de la ou des sources lumineuses et on mesure le rapport d'intensités lumineuses pour chaque fréquence de manière à obtenir un spectre en fréquence. Dans le cas des systèmes laser multi-sources décrits par référence aux Figs. 5 à 7, on peut faire une analyse simultanément ou alternativement pour les différentes fréquences des différentes sources lumineuses.

Selon un mode de réalisation, une mesure de type CRDS (Cavity Ring Down Spectroscopy) est réalisée. Dans ce mode de réalisation, l'émission de l'onde source par le laser est interrompue, alors que la cavité est remplie de photons et une mesure de la durée de vie des photons dans la cavité est effectuée. Cette durée de vie est fonction de la réflectivité des miroirs mais aussi des pertes par absorption dans le gaz présent dans la cavité. L'interruption du laser pourrait être assurée par l'utilisation d'un modulateur électro-optique configuré pour atténuer fortement l'onde laser (>60dB) ou par un amplificateur (élément 103), placé après le modulateur électro-optique dans le sens propagatif, que l'on interrompt (atténuation >80dB).

La présente description concerne un procédé de génération d'une source laser au moyen d'un système laser selon l'un quelconque des modes de réalisation décrit ici. Dans au moins un mode de réalisation, ce procédé comprend une génération d'une onde optique source propagative (LOp ; L50Ap, L60Ap, L70Ap), continue, ajustable en fréquence, dite onde source. L'onde source est générée au moyen d'un laser (110 ; 510A ; 610A ; 710A), sensible à la rétroaction optique, via une fibre optique de sortie (111 ; 511A ; 611A ; 711A) du laser.

Dans au moins un mode de réalisation, ce procédé comprend un couplage par rétroaction optique du laser avec une cavité optique résonante (120) configurée pour générer une onde intra-cavité (L5) dont une fraction revient vers le laser sous forme d'une onde contra-propagative.

Dans au moins un mode de réalisation, ce procédé comprend une génération, par un modulateur électro-optique fibré placé sur le trajet optique de l'onde source entre le laser et la cavité optique résonante, d'une onde source déphasée (L1p ; L51Ap, L61Ap, L71Ap) par déphasage de l'onde source et, par déphasage de l'onde optique contra-propagative, d'une onde contra-propagative déphasée (LOc ; L50Ac, L60Ac, L70Ac), dite onde de contre-réaction, qui parvient au laser.

Dans au moins un mode de réalisation, ce procédé comprend une génération d'un signal de commande (SC ; SC6A, SC7A) du modulateur électro-optique à partir d'un signal d'erreur (SE) représentatif de la phase relative entre l'onde source et l'onde de contre-réaction, de sorte à annuler la phase relative entre l'onde source et l'onde de contre-réaction. Le signal de commande peut être généré selon l'une quelconque des méthodes décrites par référence aux Figs. 2A- 2E, 5, 6, 7. Ce procédé est applicable aux différents systèmes laser décrits dans ce document par référence aux figs. 1, 2A à 2E, et figs. 4 à 7.

## Revendications

1. Système laser avec rétroaction optique comprenant :
- un laser (110 ; 510A ; 610A ; 710A), sensible à la rétroaction optique et destiné à émettre, via une fibre optique de sortie (111 ; 511A ; 611A ; 711A), une onde optique source propagative (LOp ; L50Ap, L60Ap, L70Ap), continue, ajustable en fréquence, dite onde source;
- une cavité optique résonante (120), couplée par rétroaction optique au laser, configurée pour générer une onde intra-cavité (L5) dont une fraction revient vers le laser sous forme d'une onde optique contra-propagative (L1c ; L51Ac, L61Ac, L71Ac) ;
- un modulateur électro-optique (115 ; 615A ; 715A) fibré, placé sur le trajet optique entre le laser et la cavité optique résonante, le modulateur électro-optique étant configuré pour générer une onde source déphasée (L1p ; L51Ap, L61Ap, L71Ap) par déphasage de l'onde source et générer, par déphasage de l'onde optique contra-propagative, une onde contra-propagative déphasée (L0c ; L50Ac, L60Ac, L70Ac), dite onde de contre-réaction, qui parvient au laser;
- un dispositif de contrôle de phase (130 ; 230A ; 230B ; 230C ; 230D ; 230E ; 530 ; 630 ; 730A) pour générer un signal de commande (SC ; SC6A, SC7A) du modulateur électro-optique à partir d'un signal d'erreur (SE) représentatif de la phase relative entre l'onde source (L0p ; L50Ap, L60Ap, L70Ap) et l'onde de contre-réaction (L0c ; L50Ac, L60Ac, L70Ac), de sorte à annuler la phase relative entre l'onde source et l'onde de contre-réaction.

2. Système laser selon la revendication 1, dans lequel :
- la cavité optique résonante (120) est formée par au moins deux miroirs dont au moins un miroir de sortie (125),
- le dispositif de contrôle de phase est configuré pour générer le signal de commande (SC) du modulateur électro-optique (115) à partir d'une fraction (L3) de l'onde intra-cavité qui sort de la cavité optique résonante via ledit miroir de sortie (125).

3. Système laser selon la revendication 1, dans lequel
- la cavité optique résonante (120) est formée par au moins deux miroirs dont un miroir d'entrée (123),
- le dispositif de contrôle de phase est configuré pour générer le signal de commande (SC) du modulateur électro-optique (115) à partir d'une onde (L6) résultant d'une interférence entre une fraction (L2r) de l'onde source déphasée qui est réfléchie par le miroir d'entrée (123) et une fraction (L2c) de l'onde intra-cavité (L5) qui est transmise dans le sens contra-propagatif via le miroir d'entrée.

4. Système laser selon la revendication 1, dans lequel le dispositif de contrôle de phase est configuré pour générer le signal de commande (SC) du modulateur électro-optique (115) à partir d'une fraction de l'onde optique contra-propagative (L1c) prélevée en entrée du modulateur électro-optique (115) dans le sens contra-propagatif.

5. Système laser selon la revendication 1, dans lequel le modulateur électro-optique est configuré en outre pour générer un signal optique modulé par modulation, en fonction du signal d'erreur, de la phase de l'onde source autour d'une valeur moyenne et le dispositif de contrôle de phase est configuré pour produire le signal de commande (SC) par une méthode de détection synchrone à partir d'une fraction de l'onde optique contra-propagative (L1c) prélevée en entrée du modulateur électro-optique (115) dans le sens contra-propagatif.

6. Système laser selon l'une quelconque des revendications précédentes, dans lequel la fibre optique de sortie est une fibre à maintien de polarisation.

7. Système laser selon l'une quelconque des revendications précédentes, dans lequel le laser est dépourvu d'isolateur optique en sortie.

8. Système laser selon l'une quelconque des revendications précédentes, comprenant au moins un composant optique fibré (102 ; 103) placé sur le trajet optique de l'onde source, avant ou après le modulateur électro-optique fibré (115), le composant optique fibré étant un composant dans le groupe constitué par un amplificateur optique, un coupleur optique, et un circulateur optique.

9. Système laser selon l'une quelconque des revendications 1 à 8, comprenant :
- au moins un deuxième laser (510B, 510C), sensible à la rétroaction optique et émettant via une fibre optique de sortie (511B, 511C) une deuxième onde optique source propagative (L50Bp, L50Cp), continue, ajustable en fréquence;
- un commutateur optique fibré (550), configuré pour recevoir les ondes optiques sources propagatives (L50Ap, L50Bp, L50Cp) en sortie du premier laser et dudit au moins un deuxième laser, pour sélectionner une des ondes optiques sources propagatives reçues et pour transférer au modulateur électro-optique fibré l'onde optique source propagative sélectionnée.

10. Système laser selon l'une quelconque des revendications 1 à 8, comprenant :
- au moins un deuxième laser (610B, 610C), sensible à la rétroaction optique et émettant via une fibre optique de sortie une deuxième onde optique source propagative (L60Bp, L60Cp) correspondante, continue, ajustable en fréquence;
- au moins un deuxième modulateur électro-optique (615B, 615C) fibré, placé sur le trajet optique entre un dit deuxième laser (610B, 610C) correspondant et la cavité optique résonante, chaque dit deuxième modulateur électro-optique étant configuré pour générer une onde optique propagative déphasée (L61Bp, L61Cp) par déphasage d'une dite deuxième onde optique source propagative (L60Bp, L60Cp) correspondante;
- un multiplexeur optique fibré (660), configuré pour recevoir les ondes optiques propagatives déphasées (L61Ap, L61Bp, L61Cp) en sortie du modulateur électro-optique et dudit au moins un deuxième modulateur électro-optique, pour générer une onde optique multiplexée (L61p) par multiplexage fréquentiel des ondes optiques propagatives déphasées reçues, pour alimenter la cavité optique résonante avec l'onde multiplexée et pour générer des ondes démultiplexées en démultiplexant une fraction de l'onde intra-cavité (L5) qui parvient au multiplexeur sous forme d'une onde optique contra-propagative,
chaque dit deuxième modulateur électro-optique étant configuré en outre pour générer, par déphasage d'une des ondes démultiplexées, une onde optique contra-propagative (L60Bc, L60Cc) correspondante qui parvient au deuxième laser correspondant,
le dispositif de contrôle de phase (630A) étant configuré pour générer un signal de commande (SC6B, SC6C) pour chaque deuxième modulateur électro-optique à partir d'un signal d'erreur (SE) représentatif de la phase relative entre une deuxième onde optique source propagative (L60Bp, L60Cp) correspondante et l'onde optique contra-propagative (L60Bc, L60Cc) correspondante parvenant au deuxième laser correspondant, de sorte à annuler la phase relative entre l'onde optique source propagative correspondante et l'onde optique contra-propagative correspondante (L60Bc, L60Cc).

11. Système laser selon l'une quelconque des revendications 1 à 8, comprenant :
- un deuxième laser (710B), sensible à la rétroaction optique et émettant via une fibre optique de sortie (711B) une deuxième onde optique source propagative (L70B), continue, ajustable en fréquence;
- un deuxième modulateur électro-optique (715B) fibré, placé sur le trajet optique entre le deuxième laser et la cavité optique résonante, le deuxième modulateur électro-optique étant configuré pour générer une deuxième onde optique propagative déphasée (L71Bp) par déphasage de la deuxième onde optique source propagative;
- un combinateur optique (780) pour générer, à partir d'une première onde optique propagative déphasée (L71Ap) générée par le modulateur électro-optique (715A) et de la deuxième onde optique propagative déphasée (L71Ac), une onde combinée (L77Cp) comprenant deux ondes polarisées orthogonalement, pour alimenter la cavité optique résonante avec l'onde combinée (L77Cp) et pour générer des ondes séparées (L71Ac, L71Bc) en séparant, dans une fraction de l'onde intra-cavité qui parvient au combinateur optique sous forme d'une onde optique contra-propagative (L77Cc), les fractions d'ondes polarisées orthogonalement;
le deuxième modulateur électro-optique (715B) étant configuré en outre pour déphaser une des ondes séparées et produire une deuxième onde optique contra-propagative (L70Bc) qui parvient au deuxième laser,
le système laser comprenant en outre un deuxième dispositif de contrôle de phase (730B) pour générer un deuxième signal de commande (SC7B) du deuxième modulateur électro-optique à partir d'un deuxième signal d'erreur représentatif de la phase relative entre la deuxième onde optique source propagative (L70Bp) et la deuxième onde optique contra-propagative (L70Bc), de sorte à annuler la phase relative entre la deuxième onde optique source propagative et la deuxième onde optique contra-propagative.

12. Système de génération d'une onde optique comprenant un système laser selon la revendication 11 et un composant optique pour générer une onde optique combinée par combinaison d'une fraction de l'onde source, respectivement de l'onde de contre-réaction, en sortie du laser (710A) et d'une fraction de la deuxième onde optique source propagative, respectivement de la deuxième onde optique contra-propagative, en sortie du deuxième laser (710B).

13. Système de détection de gaz, dans lequel la cavité optique résonante définit une enceinte destinée à recevoir au moins un gaz, le système de détection de gaz comprenant :
- un système laser selon l'une quelconque des revendications précédentes,
- un dispositif d'analyse pour analyser au moins une onde optique générée par le système laser.

14. Procédé de génération d'onde optique comprenant
- une génération d'une onde optique source propagative, continue, ajustable en fréquence, dite onde source, via une fibre optique de sortie d'un laser sensible à la rétroaction optique;
- un couplage par rétroaction optique du laser avec une cavité optique résonante configurée pour générer une onde intra-cavité dont une fraction revient vers le laser sous forme d'une onde optique contra-propagative (L0c ; L50Ac, L60Ac, L70Ac);
- une génération, par un modulateur électro-optique fibré placé sur le trajet optique de l'onde source entre le laser et la cavité optique résonante, d'une onde source déphasée (L1p ; L51Ap, L61Ap, L71Ap) par déphasage de l'onde source et, par déphasage de l'onde optique contra-propagative, d'une onde contra-propagative déphasée (L0c ; L50Ac, L60Ac, L70Ac), dite onde de contre-réaction, qui parvient au laser; et
- une génération d'un signal de commande (SC ; SC6A, SC7A) du modulateur électro-optique à partir d'un signal d'erreur (SE) représentatif de la phase relative entre l'onde source et l'onde de contre-réaction, de sorte à annuler la phase relative entre l'onde source et l'onde de contre-réaction.

## Patentansprüche

1. Lasersystem mit optischer Rückkopplung, das Folgendes umfasst:
- einen Laser (110; 510A; 610A; 710A), der für optische Rückkopplung empfindlich und zum Senden, über eine optische Ausgangsfaser (111; 511A; 611A; 711A), einer kontinuierlichen, frequenzjustierbaren, sich ausbreitenden optischen Quellwelle (L0p; L50Ap, L60Ap, L70Ap), Quellwelle genannt, bestimmt ist;
- einen optischen Resonanzhohlraum (120), der durch optische Rückkopplung mit dem Laser gekoppelt ist, konfiguriert zum Erzeugen einer Intra-Hohlraum-Welle (L5), von der ein Bruchteil in Form einer sich gegenläufig ausbreitenden optischen Welle (L1c; L51Ac, L61Ac, L71Ac) zum Laser zurückkehrt;
- einen elektrooptische Fasermodulator (115; 615A; 715A), der im Lichtweg zwischen dem Laser und dem optischen Resonanzhohlraum platziert ist, wobei der elektrooptische Modulator zum Erzeugen einer phasenverschobenen Quellwelle (L1p; L51Ap, L61Ap, L71Ap) durch Phasenverschieben der Quellwelle und Erzeugen, durch Phasenverschieben der sich gegenläufig ausbreitenden optischen Welle, einer phasenverschobenen, sich gegenläufig ausbreitenden Welle (L0c; L50Ac, L60Ac, L70Ac), Rückkopplungswelle genannt, konfiguriert ist, die den Laser erreicht;
- eine Phasensteuerung (130; 230A; 230B; 230C; 230D; 230E; 530; 630; 730A) zum Erzeugen eines Steuersignals (SC; SC6A, SC7A) für den elektrooptischen Modulator auf der Basis eines Fehlersignals (SE), das die relative Phase zwischen der Quellwelle (L0p; L50Ap, L60Ap, L70Ap) und der Rückkopplungswelle (L0c; L50Ac, L60Ac, L70Ac) repräsentiert, so dass die relative Phase zwischen der Quellwelle und der Rückkopplungswelle aufgehoben wird.

2. Lasersystem nach Anspruch 1, wobei:
- der optische Resonanzhohlraum (120) durch mindestens zwei Spiegel, darunter mindestens ein Ausgangsspiegel (125), gebildet wird,
- die Phasensteuerung zum Erzeugen des Steuersignals (SC) des elektrooptischen Modulators (115) auf der Basis eines Bruchteils (L3) der Intra-Hohlraum-Welle konfiguriert ist, die den optischen Resonanzhohlraum über den Ausgangsspiegel (125) verlässt.

3. Lasersystem nach Anspruch 1, wobei
- der optische Resonanzhohlraum (120) von mindestens zwei Spiegeln, darunter ein Eingangsspiegel (123), gebildet wird,
- die Phasensteuerung zum Erzeugen des Steuersignals (SC) des elektrooptischen Modulators (115) auf der Basis einer Welle (L6) konfiguriert ist, die aus einer Interferenz zwischen einem Bruchteil (L2r) der vom Eingangsspiegel (123) reflektierten phasenverschobenen Quellwelle und einem Bruchteil (L2c) der über den Eingangsspiegel in der Gegenausbreitungsrichtung übertragenen Intra-Hohlraum-Welle (L5) resultiert.

4. Lasersystem nach Anspruch 1, wobei die Phasensteuerung zum Erzeugen des Steuersignals (SC) des elektrooptischen Modulators (115) auf der Basis eines Bruchteils der sich gegenläufig ausbreitenden optischen Welle (L1c) konfiguriert ist, die am Eingang des elektrooptischen Modulators (115) in der Gegenausbreitungsrichtung erfasst wird.

5. Lasersystem nach Anspruch 1, wobei der elektrooptische Modulator ferner zum Erzeugen eines modulierten optischen Signals durch Modulieren, in Abhängigkeit vom Fehlersignal, der Phase der Quellwelle um einen Mittelwert konfiguriert ist, und die Phasensteuerung zum Produzieren des Steuersignals (SC) mit einem synchronen Detektionsverfahren auf der Basis eines Bruchteils der sich gegenläufig ausbreitenden optischen Welle (L1c) konfiguriert ist, die am Eingang des elektrooptischen Modulators (115) in der Gegenausbreitungsrichtung erfasst wird.

6. Lasersystem nach einem der vorherigen Ansprüche, wobei die optische Ausgangsfaser eine polarisationserhaltende Faser ist.

7. Lasersystem nach einem der vorherigen Ansprüche, wobei der Laser keinen optischen Ausgangsisolator aufweist.

8. Lasersystem nach einem der vorherigen Ansprüche mit mindestens einer faseroptischen Komponente (102; 103), die im Lichtweg der Quellwelle vor oder nach dem elektrooptischen Fasermodulator (115) platziert ist, wobei die faseroptische Komponente eine Komponente aus der Gruppe bestehend aus einem optischen Verstärker, einem optischen Koppler und einem optischen Zirkulator ist.

9. Lasersystem nach einem der Ansprüche 1 bis 8, das Folgendes umfasst:
- mindestens einen zweiten Laser (510B, 510C), der für optische Rückkopplung empfindlich ist und über eine optische Ausgangsfaser (511B, 511C) eine zweite, kontinuierliche, frequenzjustierbare, sich ausbreitende optische Quellwelle (L50Bp, L50Cp) aussendet;
- einen faseroptischen Schalter (550), konfiguriert zum Empfangen der sich ausbreitenden optischen Quellwellen (L50Ap, L50Bp, L50Cp), die von dem ersten Laser und dem mindestens einen zweiten Laser ausgegeben werden, zum Auswählen einer der empfangenen, sich ausbreitenden optischen Quellwellen und zum Übertragen der ausgewählten sich ausbreitenden optischen Quellwelle zum elektrooptischen Fasermodulator.

10. Lasersystem nach einem der Ansprüche 1 bis 8, das Folgendes umfasst:
- mindestens einen zweiten Laser (610B, 610C), der für optische Rückkopplung empfindlich ist und über eine optische Ausgangsfaser eine entsprechende kontinuierliche, frequenzjustierbare zweite sich ausbreitende optische Quellwelle (L60Bp, L60Cp) aussendet;
- mindestens einen zweiten elektrooptischen Fasermodulator (615B, 615C), der im Lichtweg zwischen einem entsprechenden zweiten Laser (610B, 610C) und dem optischen Resonanzhohlraum platziert ist, wobei jeder zweite elektrooptische Modulator zum Erzeugen einer phasenverschobenen sich ausbreitenden optischen Welle (L61Bp, L61Cp) durch Phasenverschieben einer entsprechenden zweiten sich ausbreitenden optischen Welle (L60Bp, L60Cp) konfiguriert ist;
- einen faseroptischen Multiplexer (660), konfiguriert zum Empfangen der phasenverschobenen sich ausbreitenden optischen Wellen (L61Ap, L61Bp, L61Cp) am Ausgang des elektrooptischen Modulators und des mindestens einen zweiten elektrooptischen Modulators, zum Erzeugen einer durch Frequenzmultiplexen der empfangenen phasenverschobenen sich ausbreitenden optischen Wellen gemultiplexten optischen Welle (L61p), zum Einspeisen der gemultiplexten Welle in den optischen Resonanzhohlraum und zum Erzeugen demultiplexter Wellen durch Demultiplexen eines Bruchteils der Intra-Hohlraum-Welle (L5), die den Multiplexer in Form einer sich gegenläufig ausbreitenden optischen Welle erreicht,
wobei jeder zweite elektrooptische Modulator ferner zum Erzeugen, durch Phasenverschieben einer der demultiplexten Wellen, einer entsprechenden gegenläufigen optischen Welle (L60Bc, L60Cc) konfiguriert ist, die den entsprechenden zweiten Laser erreicht,
wobei die Phasensteuerung (630A) zum Erzeugen eines Steuersignals (SC6B, SC6C) für jeden zweiten elektrooptischen Modulator auf der Basis eines Fehlersignals (SE) konfiguriert ist, das die relative Phase zwischen einer entsprechenden zweiten sich ausbreitenden optischen Quellwelle (L60Bp, L60Cp) und der entsprechenden sich gegenläufig ausbreitenden optischen Welle (L60Bc, L60Cc) repräsentiert, die den entsprechenden zweiten Laser erreicht, so dass die relative Phase zwischen der entsprechenden sich ausbreitenden optischen Quellwelle und der entsprechenden sich gegenläufig ausbreitenden optischen Welle (L60Bc, L60Cc) aufgehoben wird.

11. Lasersystem nach einem der Ansprüche 1 bis 8, das Folgendes umfasst:
- einen zweiten Laser (710B), der für optische Rückkopplung empfindlich ist und über eine optische Ausgangsfaser (711B) eine zweite, kontinuierliche, frequenzjustierbare, sich ausbreitende optische Quellwelle (L70B) aussendet;
- einen zweiten elektrooptischen Fasermodulator (715B), der im Lichtweg zwischen dem zweiten Laser und dem optischen Resonanzhohlraum platziert ist, wobei der zweite elektrooptische Modulator zum Erzeugen einer zweiten phasenverschobenen sich ausbreitenden optischen Welle (L71Bp) durch Phasenverschieben der zweiten optischen sich ausbreitenden Quellwelle konfiguriert ist;
- einen optischen Kombinierer (780) zum Erzeugen, auf der Basis einer von dem elektrooptischen Modulator (715A) erzeugten ersten phasenverschobenen sich ausbreitenden optischen Welle (L71Ap) und der zweiten phasenverschobenen sich ausbreitenden optischen Welle (L71Ac), einer kombinierten Welle (L77Cp) mit zwei orthogonal polarisierten Wellen, zum Einspeisen der kombinierten Welle (L77Cp) in den optischen Resonanzhohlraum und zum Erzeugen getrennter Wellen (L71Ac, durch Trennen, in einen Bruchteil der Intra-Hohlraum-Welle, die einen optischen Kombinierer in Form einer sich gegenläufig ausbreitenden optischen Welle (L77Cc) erreicht, der Bruchteile von orthogonal polarisierten Wellen;
wobei der zweite elektrooptische Modulator (715B) ferner zum Phasenverschieben einer der getrennten Wellen und zum Produzieren einer zweiten sich gegenläufig ausbreitenden optischen Welle (L70Bc) konfiguriert ist, die den zweiten Laser erreicht,
wobei das Lasersystem ferner eine zweite Phasensteuerung (730B) zum Erzeugen eines zweiten Steuersignals (SC7B) des zweiten elektrooptischen Modulators auf der Basis eines zweiten Fehlersignals umfasst, das die relative Phase zwischen der zweiten sich ausbreitenden optischen Quellwelle (L70Bp) und der zweiten sich gegenläufig ausbreitenden optischen Welle (L70Bc) repräsentiert, um die relative Phase zwischen der zweiten sich ausbreitenden optischen Quellwelle und der zweiten sich gegenläufig ausbreitenden optischen Welle aufzuheben.

12. System zum Erzeugen einer optischen Welle mit einem Lasersystem nach Anspruch 11 und einer optischen Komponente zum Erzeugen einer kombinierten optischen Welle durch Kombinieren eines Bruchteils der Quellwelle bzw. der Rückkopplungswelle am Ausgang des Lasers (710A) und eines Bruchteils der zweiten sich ausbreitenden optischen Quellwelle bzw. der zweiten sich gegenläufig ausbreitenden optischen Welle am Ausgang des zweiten Lasers (710B).

13. Gasdetektionssystem, wobei der optische Resonanzhohlraum eine Kammer zur Aufnahme mindestens eines Gases definiert, wobei das Gasdetektionssystem Folgendes umfasst:
- ein Lasersystem nach einem der vorherigen Ansprüche,
- ein Analysegerät zum Analysieren mindestens einer vom Lasersystem erzeugten optischen Welle.

14. Verfahren zum Erzeugen optischer Wellen, das Folgendes beinhaltet:
- Erzeugen einer kontinuierlichen, frequenzjustierbaren, sich ausbreitenden optischen Quellwelle, Quellwelle genannt, über eine optische Ausgangsfaser eines für optische Rückkopplung empfindlichen Lasers;
- optisches Rückkoppeln des Lasers mit einem optischen Resonanzhohlraum, der zum Erzeugen einer Intra-Hohlraum-Welle konfiguriert ist, von der ein Bruchteil in Form einer sich gegenläufig ausbreitenden optischen Welle (L0c; L50Ac, L60Ac, L70Ac) zum Laser zurückkehrt;
- Erzeugen, mittels eines elektrooptischen Fasermodulators, der im Lichtweg der Quellwelle zwischen dem Laser und dem optischen Resonanzhohlraum platziert ist, einer phasenverschobenen Quellwelle (L1p; L51Ap, L61Ap, L71Ap) durch Phasenverschieben der Quellwelle und durch Phasenverschieben der sich gegenläufig ausbreitenden optischen Welle (L0c; L50Ac, L60Ac, L70Ac), der so genannten Rückkopplungswelle, die den Laser erreicht; und
- Erzeugen eines Steuersignals (SC; SC6A, SC7A) des elektrooptischen Modulators auf der Basis eines Fehlersignals (SE), das die relative Phase zwischen der Quellwelle und der Rückkopplungswelle repräsentiert, um die relative Phase zwischen der Quellwelle und der Rückkopplungswelle aufzuheben.

## Claims

1. A laser system with optical feedback comprising:
- a laser (110; 510A; 610A; 710A) that is sensitive to optical feedback and intended to emit, via an output optical fiber (111; 511A; 611A; 711A), a continuous-waveform forward-propagating source optical wave (L0p; L50Ap, L60Ap, L70Ap) called the source wave, the frequency of which is adjustable;
- a resonant optical cavity (120) that is coupled by optical feedback to the laser and that is configured to generate an intra-cavity wave (L5) a fraction of which is returned to the laser in the form of a back-propagating optical wave (L1c; L51Ac, L61Ac, L71Ac);
- a fiber-based electro-optical modulator (115; 615A; 715A) placed on the optical path between the laser and the resonant optical cavity, the electro-optical modulator being configured to generate a phase-shifted source wave (L1p; L51Ap, L61Ap, L71Ap) by phase shifting the source wave and to generate, by phase shifting the back-propagating optical wave, a phase-shifted back-propagating wave (L0c; L50Ac, L60Ac, L70Ac), called the feedback wave, which reaches the laser;
- a phase-controlling device (130; 230A; 230B; 230C; 230D; 230E; 530; 630; 730A) for generating a signal (SC; SC6A, SC7A) for controlling the electro-optical modulator from an error signal (SE) representative of the relative phase between the source wave (L0p; L50Ap, L60Ap, L70Ap) and the feedback wave (L0c; L50Ac, L60Ac, L70Ac), so as to cancel out the relative phase between the source wave and the feedback wave.

2. The laser system as claimed in claim 1, wherein:
- the resonant optical cavity (120) is formed by at least two mirrors including at least one output mirror (125),
- the phase-controlling device is configured to generate the signal (SC) for controlling the electro-optical modulator (115) from a fraction (L3) of the intra-cavity wave that exits from the resonant optical cavity via said output mirror (125).

3. The laser system as claimed in claim 1, wherein
- the resonant optical cavity (120) is formed by at least two mirrors including an input mirror (123),
- the phase-controlling device is configured to generate the signal (SC) for controlling the electro-optical modulator (115) from a wave (L6) resulting from interference between a fraction (L2r) of the phase-shifted source wave reflected by the input mirror (123) and a fraction (L2c) of the intra-cavity wave (L5) transmitted in the back-propagation direction via the input mirror.

4. The laser system as claimed in claim 1, wherein the phase-controlling device is configured to generate the signal (SC) for controlling the electro-optical modulator (115) from a fraction of the back-propagating optical wave (L1c) sampled at the input of the electro-optical modulator (115) in the back-propagation direction.

5. The laser system as claimed in claim 1, wherein the electro-optical modulator is furthermore configured to generate a modulated optical signal by modulating, depending on the error signal, the phase of the source wave about an average value and the phase-controlling device is configured to produce the control signal (SC) via a lock-in detection method from a fraction of the back-propagating optical wave (L1c) sampled at the input of the electro-optical modulator (115) in the back-propagation direction.

6. Laser system according to any one of the preceding claims, wherein the output optical fiber is a polarization-maintaining fiber.

7. The laser system as claimed in any one of the preceding claims, wherein the laser is devoid of an optical isolator at its output.

8. The laser system as claimed in any one of the preceding claims, comprising at least one fiber-based optical component (102; 103) placed on the optical path of the source wave, before or after the fiber-based electro-optical modulator (115), the fiber-based optical component being a component selected from the group made up of an optical amplifier, an optical coupler, and an optical circulator.

9. The laser system as claimed in any one of claims 1 to 8, comprising:
- at least one second laser (510B, 510C) that is sensitive to optical feedback and that emits, via an output optical fiber (511B, 511C), a second continuous-waveform forward-propagating source optical wave (L50Bp, L50Cp) the frequency of which is adjustable;
- a fiber-based optical switch (550) configured to receive the forward-propagating source optical waves (L50Ap, L50Bp, L50Cp) output from the first laser and said at least one second laser, for selecting one of the received forward-propagating source optical waves and for transferring, to the fiber-based electro-optical modulator, the selected forward-propagating source optical wave.

10. The laser system as claimed in any one of claims 1 to 8, comprising:
- at least one second laser (610B, 610C) that is sensitive to optical feedback and that emits, via an output optical fiber, a corresponding second continuous-waveform forward-propagating source optical wave (L60Bp, L60Cp) the frequency of which is adjustable;
- at least one second fiber-based electro-optical modulator (615B, 615C) placed on the optical path between a corresponding said second laser (610B, 610C) and the resonant optical cavity, each said second electro-optical modulator being configured to generate a phase-shifted forward-propagating optical wave (L61Bp, L61Cp) by phase shifting a corresponding said second forward-propagating source optical wave (L60Bp, L60Cp);
- a fiber-based optical multiplexer (660) configured to receive the phase-shifted forward-propagating optical waves (L61Ap, L61Bp, L61Cp) output from the electro-optical modulator and said at least one second electro-optical modulator, for generating a multiplexed optical wave (L61p) by frequency multiplexing the received phase-shifted forward-propagating optical waves, for supplying the resonant optical cavity with the multiplexed wave and for generating demultiplexed waves by demultiplexing a fraction of the intra-cavity wave (L5) that reaches the multiplexer in the form of a back-propagating optical wave,
each said second electro-optical modulator furthermore being configured to generate, by phase shifting one of the demultiplexed waves, a corresponding back-propagating optical wave (L60Bc, L60Cc) that reaches the corresponding second laser,
the phase-controlling device (630A) being configured to generate a control signal (SC6B, SC6C) for each second electro-optical modulator from an error signal (SE) representative of the relative phase between a corresponding second forward-propagating source optical wave (L60Bp, L60Cp) and the corresponding back-propagating optical wave (L60Bc, L60Cc) reaching the corresponding second laser, so as to cancel out the relative phase between the corresponding forward-propagating source optical wave and the corresponding back-propagating optical wave (L60Bc, L60Cc).

11. The laser system as claimed in any one of claims 1 to 8, comprising:
- a second laser (710B) that is sensitive to optical feedback and that emits, via an output optical fiber (711B), a second continuous-waveform forward-propagating source optical wave (L70B) the frequency of which is adjustable;
- a second fiber-based electro-optical modulator (715 B) placed on the optical path between the second laser and the resonant optical cavity, the second electro-optical modulator being configured to generate a second phase-shifted forward-propagating optical wave (L71Bp) by phase shifting the second forward-propagating source optical wave;
- an optical combiner (780) for generating, from a first phase-shifted propagating optical wave (L71Ap) generated by the electro-optical modulator (715A) and the second phase-shifted forward-propagating optical wave (L71Ac), a combined wave (L77Cp) comprising two orthogonally polarized waves, for supplying the resonant optical cavity with the combined wave (L77Cp) and for generating split waves (L71Ac, by splitting, in a fraction of the intra-cavity wave that reaches the optical combiner in the form of a back-propagating optical wave (L77Cc), fractions of orthogonally polarized waves;
the second electro-optical modulator (715B) furthermore being configured to phase shift one of the split waves and to produce a second back-propagating optical wave (L70Bc) that reaches the second laser,
the laser system furthermore comprising a second phase-controlling device (730B) for generating a second signal (SC7B) for controlling the second electro-optical modulator from a second error signal representative of the relative phase between the second forward-propagating source optical wave (L70Bp) and the second back-propagating optical wave (L70Bc), so as to cancel out the relative phase between the second forward-propagating source optical wave and the second back-propagating optical wave.

12. A system for generating an optical wave comprising a laser system as claimed in claim 11 and an optical component for generating a combined optical wave by combining a fraction of the source wave and of the feedback wave, respectively, at the output of the laser (710A) and a fraction of the second forward-propagating source optical wave and of the second back-propagating optical wave, respectively, at the output of the second laser (710B).

13. A gas-detecting system, wherein the resonant optical cavity defines a chamber intended to receive at least one gas, the gas-detecting system comprising:
- a laser system as claimed in any one of the preceding claims,
- an analyzing device for analyzing at least one optical wave generated by the laser system.

14. A method for generating an optical wave, comprising
- generating a continuous-waveform forward-propagating source optical wave, called the source wave, the frequency of which is adjustable, via an output optical fiber of a laser that is sensitive to optical feedback;
- coupling, by optical feedback, the laser to a resonant optical cavity configured to generate an intra-cavity wave a fraction of which is returned to the laser in the form of a back-propagating optical wave (L0c; L50Ac, L60Ac, L70Ac);
- generating, with a fiber-based electro-optical modulator placed on the optical path of the source wave between the laser and the resonant optical cavity, a phase-shifted source wave (L1p; L51Ap, L61Ap, L71Ap) by phase shifting the source wave and, by phase shifting the back-propagating optical wave, a phase-shifted back-propagating wave (L0c; L50Ac, L60Ac, L70Ac), called the feedback wave, which reaches the laser; and
- generating a signal (SC; SC6A, SC7A) for controlling the electro-optical modulator from an error signal (SE) representative of the relative phase between the source wave and the feedback wave, so as to cancel out the relative phase between the source wave and the feedback wave.
